# EUROPEAN PATENT SPECIFICATION

(11) **EP 1 786 884 B1**
(45) Date of publication and mention of the grant of the patent: **20.08.2008**
(21) Application number: 05777084.4
(22) Date of filing: 26.08.2005
(51) Int. Cl.: C09K 11/06, H01L 51/30, H05B 33/14

(54) **LIGHT-EMITTING BODY, LIGHTING DEVICE AND DISPLAY DEVICE USING THE SAME**
LICHTEMITTIERENDER KÖRPER UND DARAUF BASIERENDE BELEUCHTUNGSVORRICHTUNG UND DISPLAY-VORRICHTUNG
CORPS LUMINESCENT, DISPOSITIF LUMINESCENT ET DISPOSITIF D"AFFICHAGE UTILISANT LEDIT CORPS

(30) Priority: 31.08.2004 JP 2004252724; 12.10.2004 JP 2004297520; 19.10.2004 JP 2004303623; 08.06.2005 JP 2005168323
(43) Date of publication of application: 23.05.2007
(73) Proprietor: Showa Denko K.K., Tokyo 105-8513 (JP)
(72) Inventor: SHINOZAKI, Kenji, Corp R & D Center SHOWA DENKO KK, Chiba-shi, CHiba 267-0056 (JP); HANAWA, Kenzo, Corp R & D Center. SHOWA DENKO KK, Chiba-shi, Chiba 267-0056 (JP); TAKAHASHI, Yoshiaki, Corp R & D Cr, SHOWA DENKO KK, Chiba-shi, Chiba 267-0056 (JP); KATO, Tsuyoshi, Corp R & D Center, Showa DENKO KK, Chiba-shi, Chiba 267-0056 (JP); WATANABE, Takeo, Corp R & D Center SHOWA DENKO KK, Chiba-shi, Chiba 267-0056 (JP)
(74) Representative: Strehl, Peter
(86) International application number: PCT/JP2005/016064
(87) International publication number: WO 2006/025512

(56) References cited:
- EP-A- 1 398 363
- US-A1- 2003 162 299

## Description

### TECHNICAL FIELD

The present invention relates to a light-emitting body that uses an organic fluorescent dye, is excellent in the luminous efficiency and color rendering properties and long in the lifetime, and lighting and display devices using the same.

### BACKGROUND ART

Conventionally, as a light source of a lighting device or a non-self-luminous type display device, a cold cathode tube or a light-emitting diode has been used. However, the cold cathode tube is narrow in the color reproduction range and poor in the color rendering properties, and furthermore use of mercury involves problems in light of environmental protection.

In recent years, a blue-emitting diode has been found, and a white light source obtained by combining this with a yellow light-emitting fluorescent substance is becoming popular. In this technique, combination of blue emission in the proximity of 460 nm with a fluorescent material that emits yellow light when excited by the above emission wavelength in the range of 550 to 590 nm enables emission of white light. As a fluorescent material that emits yellow light when excited by blue light, a cerium-activated yttrium/aluminum oxide base fluorescent material is known. However, the system does not contain genuine green and red components in the light source; accordingly, there are problems in that the combination is inferior in the color rendering properties as lighting and is narrower in the color reproduction range when it is used as a backlight of a display.

Furthermore, when the blue light-emitting diode and existing red and green light-emitting diodes are combined, a white light source that is wide in the color reproduction range and excellent in the color rendering properties can be obtained. However, since three light-emitting diodes have to be used, three power supplies and control systems are required, which leads to complication of the system.

Recently, a UV-emitting diode has been found and, by combining this with fluorescent substances that absorb UV light and emit in red, green and blue, a white light source using a single light-emitting diode has been realized ("Hakushoku LED Shoumei Sisutem no Koukido/koukouritu/choujyumyouka Gijyutu" (Technology for obtaining Higher Brightness, Higher Efficiency and Longer Lifetime in White LED Lighting System), Technical Information Society, Page 7, 2003). However, in the method, the photo-deterioration of constituent members due to UV-light cannot be avoided; accordingly, it does not have the lifetime practically sufficient as a light source.

Furthermore, examples of fluorescent materials that are used for converting wavelength in the field of existing LEDs includes oxides such as Ce-activated yttrium/aluminum oxides and Eu-activated strontium silicates and nitrides such as Eu-activated sialon and generally, when these materials are used, powders thereof are mixed with a resin. In this case, there are problems in that separation tends to occur at the interface between the powder and the resin, which results in inferior durability, and that difference in the refractive indices between the powder and the resin, causing generation of hiding power in some cases of certain powder concentration and certain particle size distribution, hinders obtaining high brightness.

### DISCLOSURE OF THE INVENTION

The invention intends to overcome the problems of the various kinds of LED light sources. That is, an object of the invention is to provide a light-emitting body that contains red (R), green (G) and blue (B) wavelength components to be wide in the color reproduction range, can be driven with a single power supply and control system, and does not cause photo-deterioration of constituent members.

The present inventors have conducted extensive studies, and as a result have found that an organic fluorescent dye comprising a particular iridium complex absorbs light in a wavelength region from 350 to 530 nm and efficiently emits in red and green with high color purity. Furthermore, the inventors have succeeded in obtaining a light emitting device that can generate almost all colors in the chromaticity coordinate, by combining the iridium complex with a gallium nitride compound that generates light in a wavelength region of 350 to 530 nm when a voltage is applied to a semiconductor, and thereby completed the invention.

That is, the invention relates to fluorescent substances below and a lighting device and a display device using the same.
1. A light-emitting body comprising a primary luminescent unit and a secondary luminescent unit that emits light owing to light emitted from the primary luminescent unit, wherein the secondary luminescent unit contains an iridium complex represented by formula (1)

   L¹L²L³Ir (1)

   wherein L¹, L² and L³ are organic bidentate ligands coordinated to iridium, and at least one of these ligands coordinates with a nitrogen atom and a carbon atom, and the primary luminescent unit emits light of a wavelength in the range of 350 to 530 nm.
2. The light-emitting body according to 1 above, wherein the iridium complex is represented by formula (2) 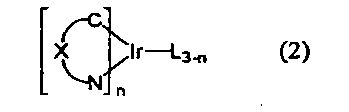 wherein X represents an atom group that forms an aromatic chelate ligand together with a carbon atom and a nitrogen atom bonded with iridium, n is an integer of 2 or 3, the multiple X's present in each aromatic chelate group may be the same or different from each other, and L represents a bidentate organic ligand wherein the atoms other than carbon atoms are bonded with iridium.
3. The light-emitting body according to 2 above, wherein the inside of [ ] in formula (2) is any one of ligands selected from a group of structural formulas shown by formula (3) 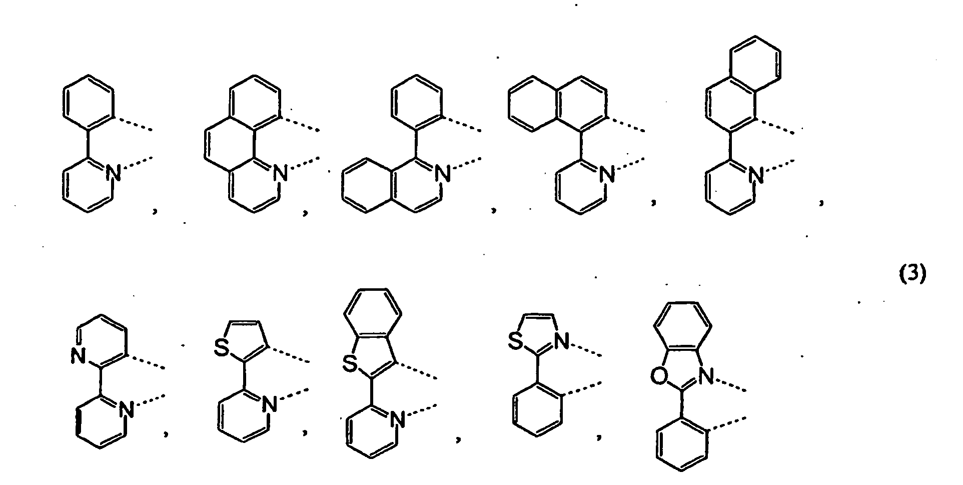 wherein a dotted line shows bonding with iridium, each hydrogen atom on the aromatic rings may be substituted by a halogen atom or an organic group having 1 to 15 carbon atoms, and when n represents a.plural number, the ligands may be different from each other.
4. The light-emitting body according to 2 above, wherein the iridium complex is represented by formula (4) 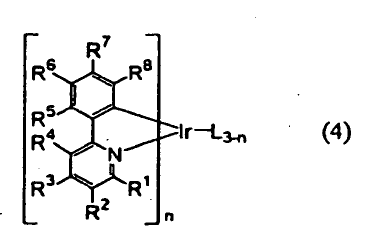 wherein R¹ through R⁸ independently represent a hydrogen atom, a halogen atom or an organic group having 1 to 15 carbon atoms, substituent groups (R¹ through R⁸) adjacent to each other may be bonded at one or more sites to thereby form a condensed ring, n is an integer of 2 or 3, two or three ligands shown by the inside of [ ] may be same or different from each other, and L represents a bidentate organic ligand wherein the atoms other than carbon atom are bonded to iridium.
5. The light-emitting body according to 2 above, wherein the iridium complex is represented by formula (5) or (6) 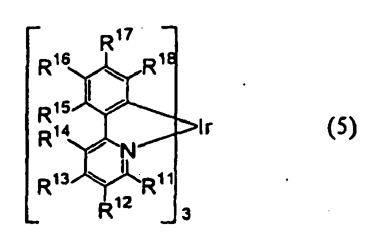 wherein R¹¹ through R¹⁸ independently represent a hydrogen atom or an alkyl group having 1 to 10 carbon atoms, 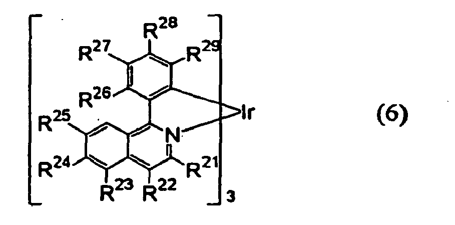 wherein R²¹ through R²⁹ independently represent a hydrogen atom or an alkyl group having 1 to 10 carbon atoms.
6. The light-emitting body according to any one of 2 to 4 above,
   wherein the bidentate organic ligand L is any one ligand selected from a group of structural formulas shown by formula (7) 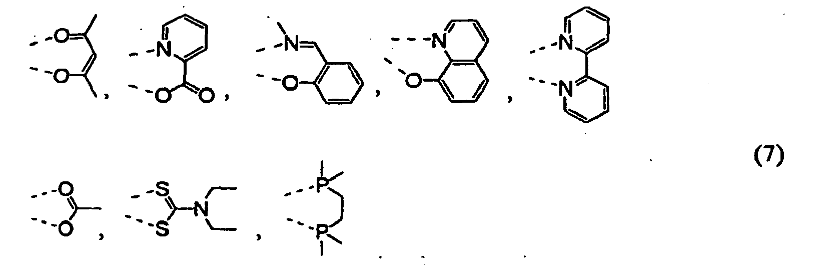 wherein a dotted line shows bonding with iridium, and a carbon atom in each of the ligands may be substituted by an organic group having 1 to 15 carbon atoms.
7. The light-emitting body according to 1 above, wherein the secondary luminescent unit is one obtained by forming an iridium complex in layer form on a transparent substrate or on the emission surface of the primary luminescent unit.
8. The light-emitting body according to 7 above, wherein the secondary luminescent unit on a transparent substrate or on the emission surface of the primary luminescent unit consists of multiple layers.
9. The light-emitting body according to 8 above, wherein the secondary luminescent unit consists of a composition layer containing an iridium complex provided on a transparent substrate or on the emission surface of the primary luminescent unit and another composition layer containing no iridium complex further laminated thereon.
10. The light-emitting body according to 8 above, wherein the secondary luminescent unit consists of a composition layer containing no iridium complex provided on a transparent substrate or on the emission surface of the primary luminescent unit, another composition layer containing an iridium complex which layer is further laminated thereon and still another composition layer containing no iridium complex which layer is still further laminated thereon.
11. The light-emitting body according to 10 above, wherein the composition layer containing no iridium complex which layer is laminated on the composition layer containing an iridium complex is a CVD carbon-coated layer.
12. The light-emitting body according to 7 above, wherein the iridium complex is an iridium complex having a bidentate organic ligand L represented by formula (7) described in above 6.
13. The light-emitting body according to 7 above, wherein the iridium complex is one or more compounds selected from a group of iridium complexes shown by formulas (E1) through (E32) below 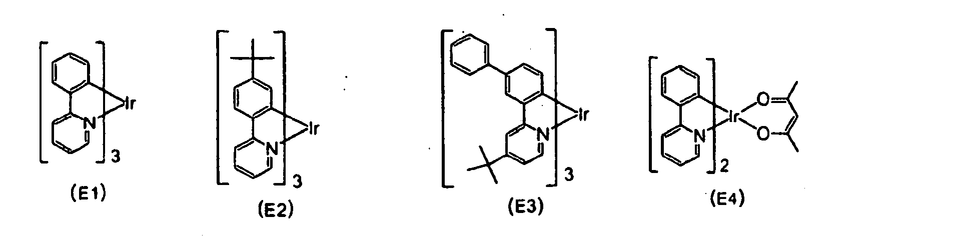 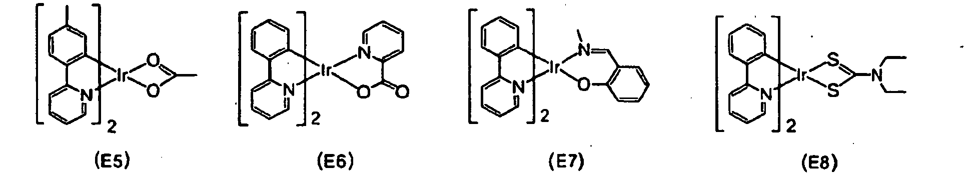 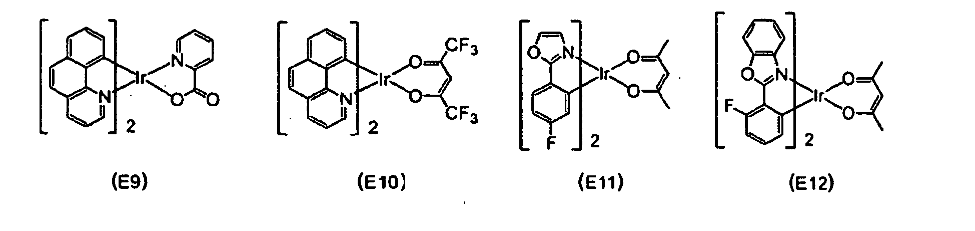 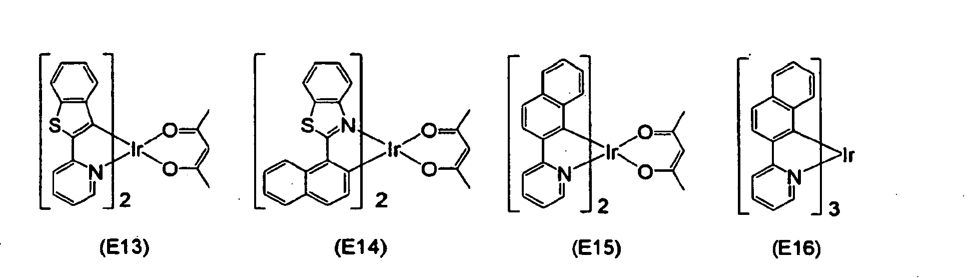 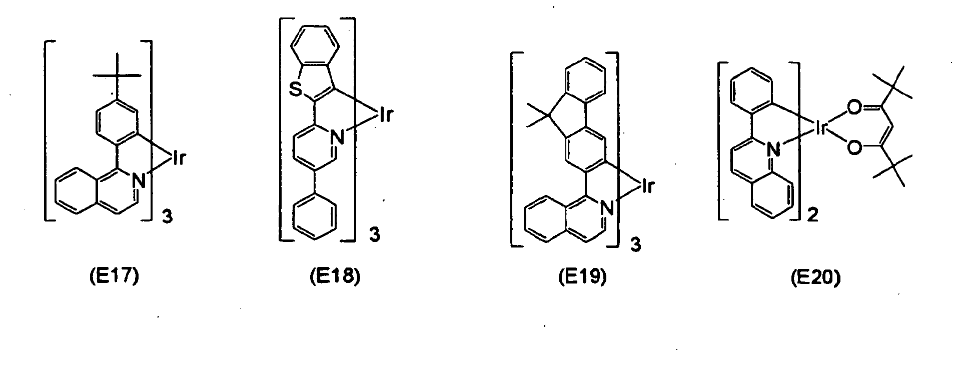 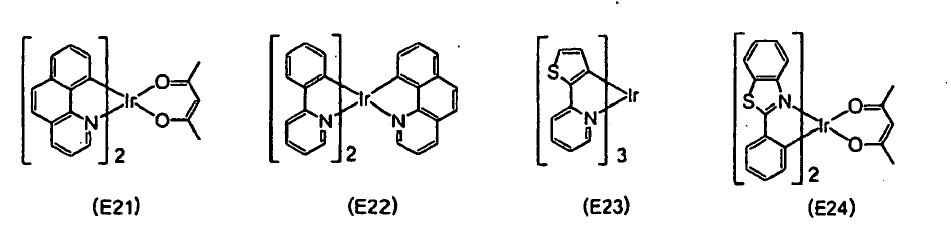 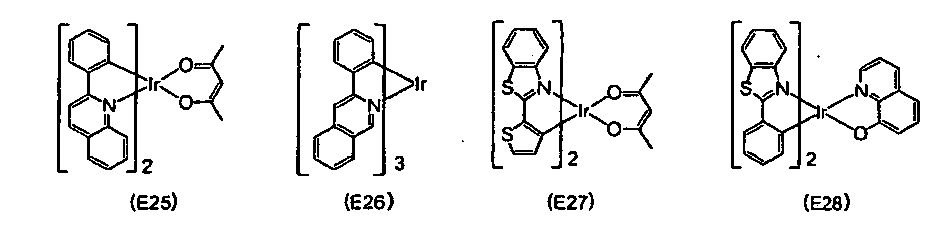 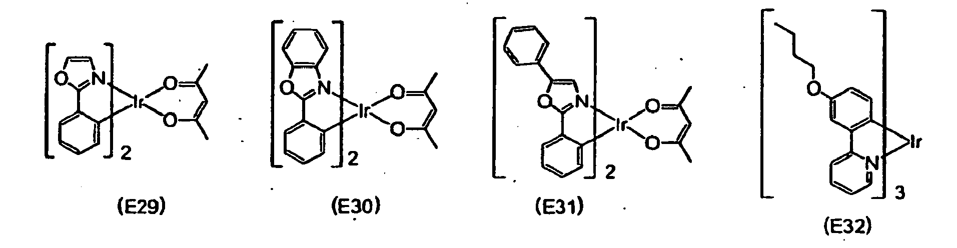
14. The light-emitting body according to 1 above, wherein the secondary luminescent unit is prepared by dissolving or dispersing an iridium complex in a binder and the secondary luminescent unit is placed in such a manner that the emission surface of the primary luminescent unit is covered.
15. The light-emitting body according to 1 above, wherein the primary luminescent unit is a blue light-emitting diode.
16. The light-emitting body according to 15 above, wherein the primary luminescent unit is a gallium nitride compound semiconductor.
17. The light-emitting body according to 1 above, comprising a structure wherein on a light path of light generated by the primary luminescent unit, the secondary luminescent unit containing a binder having an iridium complex dissolved or dispersed therein is disposed to emit white light.
18. The light-emitting body according to 17 above, wherein the secondary luminescent unit disposed on a light path of light generated by the primary luminescent unit contains a binder having at least two kinds of iridium complexes including an iridium complex having an emission peak in 510 to 570 nm and an iridium complex having an emission peak in 600 to 680 nm dissolved or dispersed therein.
19. The light-emitting body according to any one of 1 through 18 above, wherein the color rendering index is 80 or more.
20. The light-emitting body according to 18 above, wherein the primary luminescent unit is a light-emitting diode remitting light having a wavelength in 350 to 530 nm and white light with a color rendering index of 90 or more is extracted.
21. The light-emitting body according to 17 or 18 above, wherein the binder is used as a light guide plate or a diffuser plate.
22. A method of producing the light-emitting body according to 7, wherein the secondary luminescent unit containing an iridium complex is formed on a transparent substrate which receives light from the primary luminescent unit by any one method of coating, spin-coating and printing.
23. A method of producing the light-emitting body according to 7, wherein the secondary luminescent unit containing an iridium complex is formed on the emission surface of the primary luminescent unit by any one method of curing after dripping, printing and sealing, dispenser method, transfer-molding, injection-molding and spin-coating.
24. A lighting device including the light-emitting body according to any one of 1 through 21 above.
25. A display device including the light-emitting body according to any one of 1 through 21 above.
26. The display device according to 25 above, using the light-emitting body as a backlight.
27. The display device according to 25 or 26 above, wherein a light-emitting body is formed on one surface of the transparent substrate to be a secondary luminescent unit, further on the light-emitting body or on a surface opposite to the surface on which the light-emitting body is formed, a transparent electrode is formed, and the transparent electrode is used as one electrode of a transmissive liquid crystal display device.
28. A planar light-emitting device comprising multiple primary luminescent units, a secondary luminescent unit which is excited by light emitted by the primary luminescent units to emit light, alightguideplate, a reflectorplate and a diffuserplate, wherein the secondary luminescent unit contains an iridium compound as defined above.
29. The planar light-emitting device according to 28, wherein all the contact surfaces of the constituents constituting the planar light-emitting device are closely adhered to and integrated with each other in such a manner that substantially no air can be present in the interfaces.
30. The planar light-emitting device according to 29, wherein the constituents are bonded with adhesive agent or by thermocompression.
31. The planar light-emitting device according to 30, wherein the adhesive agent is an epoxy resin having a refractive index of 1.4 or more or an acrylic resin having a refractive index of 1.4 or more.
32. The planar light-emitting device according to 30, wherein the secondary luminescent unit is formed by dissolving or dispersing the iridium compound in the adhesive agent for bonding the multiple primary luminescent units with the light guide plate.
33. The planar light-emitting device according to 28, wherein the primary luminescent units are placed in multiple dents formed in the edge portion of the light guide plate.
34. The planar light-emitting device according to 33, wherein the cross-section of a light entrance face of the dent of the light guide plate has a gibbous form and the adhesive agent used for sealing the dent portions has a higher refractive index than the refractive index of the light guide plate.
35. The planar light-emitting device according to 28, wherein the reflector plate is an aluminum plate, a white-coated aluminum plate, an evaporated silver film or a white film.
36. The planar light-emitting device according to 28, wherein the primary luminescent units are light-emitting diodes.
37. A liquid crystal display backlight system using the planar light-emitting device according to any one of 28 to 36.

The light-emitting body according to the invention, which enables emission of almost all colors in the chromaticity coordinate and is wide in the color reproduction region, excellent in the color renderingproperties and free from a problem of the UV deterioration of component members, is useful as a white light source.

### BRIEF DESCRIPTION OF THE DRAWINGS

Fig. 1 is a diagram showing an emission spectrum of a light-emitting body according to the invention.
Fig. 2 is a diagram showing chromaticity coordinates of the light-emitting body according to the invention. A solid line of a triangle shows a color reproduction range of a liquid crystal display where an existing cold cathode tube is used.
Fig. 3 is a diagram showing a schematic sectional view of a backlight unit (Example 19) according to the invention.
Fig. 4 is a diagram showing a schematic sectional view of a photoluminescent type liquid crystal display device (Example 20) according to the invention.
Fig. 5 is a typical cross-sectional view of the backlight unit prepared in Example 23.
Fig. 6 is a typical cross-sectional view of the backlight unit prepared in Reference Example 1.
Fig. 7 is a typical cross-sectional view of chip-type light-emitting diode element used in Examples 23-25.

### BEST MODE FOR CARRYING OUT THE INVENTION

As the primary luminescent unit in the invention, one which can emit light in such a wavelength region that the primary light emission can be absorbed by the secondary luminescent unit to thereby emit light can be cited. Specific examples thereof include a light-emitting diode, a fluorescent tube, a mercury lamp, a halogen lamp and a xenon lamp. Among these, from a viewpoint of downsizing of device, a light-emitting diode is preferable.

Furthermore, as a display device or a lighting device, it is preferable that light of the primary luminescent unit and light of the secondary luminescent unit be combined to produce white light and that the color reproduction range be wide. In order to realize this, a light-emitting diode having an emission wavelength in 350 to 530 nm is used as the primary luminescent unit. Examples of such a light-emitting diode include gallium nitride compound semiconductors.

The gallium nitride compound semiconductor contains nitrogen as a V-group element and may additionally contains arsenic, phosphorus or the like. Furthermore, as a III-group element, in addition to gallium, aluminum, indium or boron can be contained.

In a gallium nitride compound semiconductor LED, as a substrate, sapphire, silicon carbide, silicon, gallium phosphide, gallium arsenide and gallium nitride can be used. After a crystal layer containing an LED structure is once grown, the substrate can be peeled off. The most frequently used among these is sapphire, which is inexpensive and easy to handle. In order to enhance the luminous intensity, removal of the substrate from the LED structure is effective.

In an LED chip of a gallium nitride base compound semiconductor, InGaN, GaN, AlGaN or the like can be used as a light-emitting layer. As for the structure of the light-emitting layer, in addition to a relatively thick structure where the light-emitting layer has a thickness of several hundred nanometers, a quantum well structure consisting of a thin well layer of several nanometers and a barrier layer. Examples of the quantum well structure include a single quantumwell structure (SQW structure) made of a single well layer and a multi-quantum well structure (MQW structure) made of multiple quantum wells. For the purpose of obtaining strong luminescence intensity, it is preferable that the light-emitting layer have a quantum well structure.

It is preferable that light emitted from an LED chip for light excitation have a wavelength in the range of 350 to 500 nm, more desirably in the range of 375 to 470 nm and most desirably in the range of 380 to 460 nm.

Furthermore, in order to prevent the fluorescent material from deterioration due to heat generation, it is preferable that the configuration of the LED be free from ohmic resistance, if possible. Ohmic contact components can be judged from a driving voltage of the LED chip, and a preferable driving voltage at 20 mA is 4.0 V or less, more preferably, 3.5 V or less and optimally 3.3 V or less.

Similarly, in order to prevent the fluorescent material from deterioration due to heat generation, it is preferable that a chip for higher brightness be used. Higher brightness means more efficient conversion of electric current energy into light energy, that is, less heat generation. Specifically, in bare chip measurement under a current flow of 20 mA, it is preferable that the bare chip exhibit luminescence of 5 mW or more, more preferably 7 mW or more, and most preferably 9 mW or more. The "bare chip measurement" here is to measure the total luminous flux by use of an integrating sphere, with a chip simply mounted on a mounting member called as canister type and without molding with resin.

The chip used here may have any shape generally known, without any limitation.

In case of using a chip having a silicon carbide substrate or a chip where a laminate structure is peeled off a substrate, electrodes can be attached onto both surfaces of the chip.

On the other hand, in case of using a chip having an insulating material such as sapphire as its substrate, a negative electrode and a positive electrode are provided on one same surface. In this case, the chip may have a structure called a flip-chip where light is extracted from the sapphire substrate side or a structure called a face-up where a translucent electrode is provided on an epitaxial layer side.

Furthermore, in order to promote extraction of light, by making side surfaces of the chip non-perpendicular to the top surface, emitted light can be efficiently utilized to excite the iridium complex.

Any iridium compound can be used as the secondary luminescent unit in the invention, as far as it can emit owing to light from the primary luminescent unit. As the iridium compound, an iridium complex is used.

As the iridium complex, one that is represented by formula (1)

[Chem. 11] L¹L²L³Ir (1)

wherein bidentate organic ligands L¹, L² and L³ are coordinated to iridium is used. Here, at least one of L¹, L² and L³ is a bidentate organic ligand coordinated through a nitrogen atom and carbon atom thereof to iridium.

Specific examples of the iridium complex include complexes represented by formula (2). 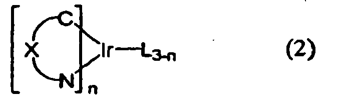 (In the formula, X represents an atom group that forms an aromatic chelate ligand together with a carbon atom and a nitrogen atom bonded with iridium, n is an integer of 2 or 3, the multiple X's in each aromatic chelate group may be the same or different from each other, and L represents a bidentate organic ligand wherein the atoms other than carbon atoms are bonded with iridium.)

Furthermore, the inside of [ ] in formula (2) is preferably any one of ligands selected from a group of structural formulas shown by formula (3). 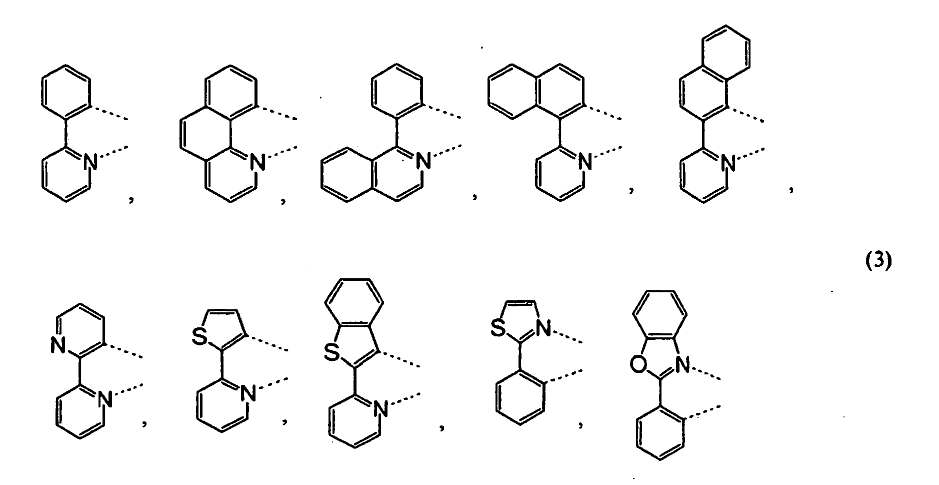 (In the formula, a dotted line shows bonding with iridium, the each hydrogen atom of an aromatic ring may be substituted by a halogen atom or an organic group having 1 to 15 carbon atoms, andwhenn represents a plural number, the ligands may be different from each other.)

Still furthermore, the iridium complex of formula (2) is preferably a complex represented by formula (4). 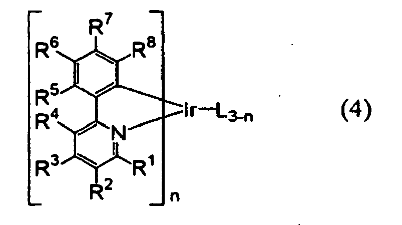 (In the formula, R¹ through R⁸ independently represent a hydrogen atom, a halogen atom or an organic group having 1 to 15 carbon atoms, substituent groups (R¹ through R⁸) adjacent to each other may be bonded at one or more sites to thereby form a condensed ring, n is an integer of 2 or 3, two or three ligands shown inside of [ ] may be the same or different from each other, and L represents a bidentate organic ligand wherein the atoms other than a carbon atom are bonded to iridium.).

Examples of the organic groups having 1 to 15 carbon atoms in formulas (3) and (4) include a cyano group, an alkyl group having 1 to 10 carbon atoms (methyl group, ethyl group, propyl group, isopropyl group, butyl group, isobutyl group, t-butyl group, amyl group, hexyl group, octyl group, decyl group or the like), an aryl group having 6 to 10 carbon atoms (phenyl group, tolyl group, xylyl group, mesityl group, naphthyl group or the like), an amino group that may be substituted by an alkyl group having 1 to 10 carbon atoms (amino group, dimethylamino group, diethylamino group, dibutylamino group or the like), an alkoxy group having 1 to 10 carbon atoms (methoxy group, ethoxy group, propoxy group, isopropoxy group, butoxy group, isobutoxy group, t-butoxy group, hexyloxy group, 2-ethylhexyloxy group, decyloxy group or the like) and a silyl group (trimethylsilyl group, triethylsilyl group, t-butyldimethylsilyl group or the like).

As examples that exhibit particularly excellent light emission of green and red among the iridium complexes shown by formula (4), compounds represented respectively by formula (5) 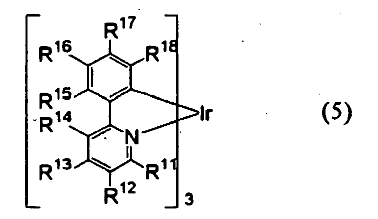 (in the formula, R¹¹ through R¹⁸ independently represent a hydrogen atom or an alkyl group having 1 to 10 carbon atoms),
or formula (6) 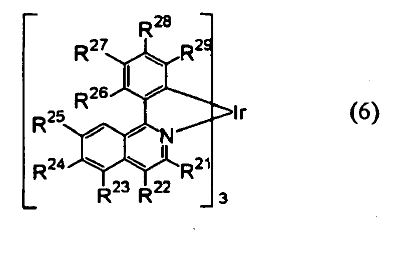 (in the formula, R²¹ through R²⁹ independently represent a hydrogen atom or an alkyl group having 1 to 10 carbon atoms) can be cited.

Examples of the alkyl group having 1 to 10 carbon atoms in formulas (5) and (6) include a methyl group, an ethyl group, a propyl group, an isopropyl group, a butyl group, an isobutyl group, a t-butyl group, an amyl group, a hexyl group, an octyl group and a decyl group.

Furthermore, the bidentate organic ligand L in formula (2) is preferably any one ligand selected from a group of structural formulas shown by formula (7) 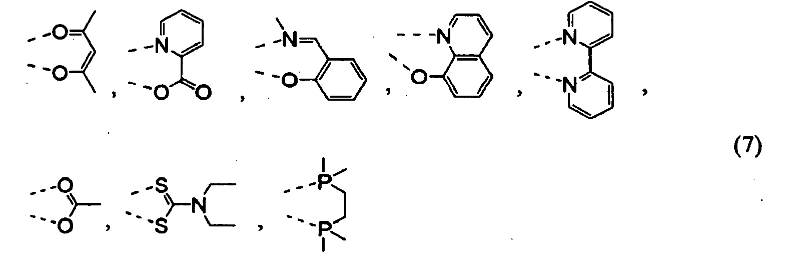 (in the formula, a dotted line shows a portion through which binds with iridium, and a carbon atom in each ligand may be substituted by an organic group having 1 to 15 carbon atoms). As specific examples of the organic groups having 1 to 15 carbon atoms according to formula (7), those mentioned in relation to formulas (3) and (4) can be cited.

As specific examples of the iridium complexes that are used in the invention, a group of iridium complexes having structures shown by formulas (E1) through (E32) below can be cited. 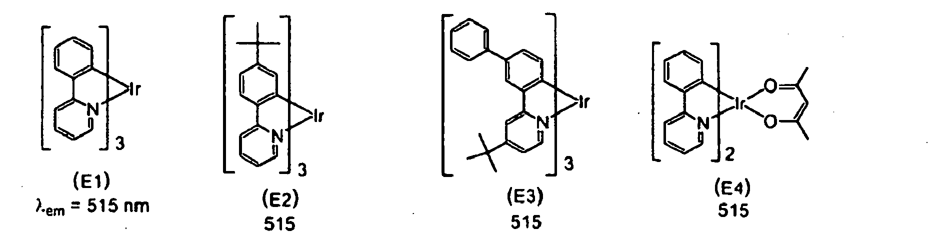 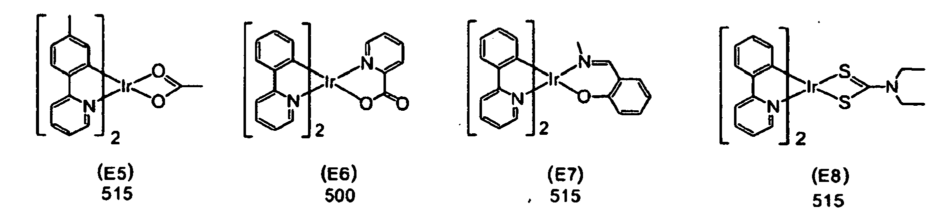 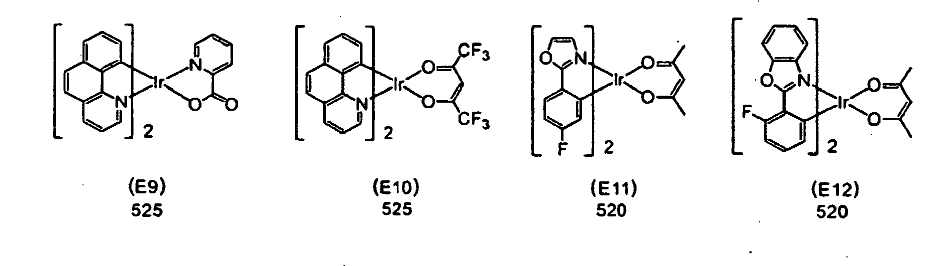 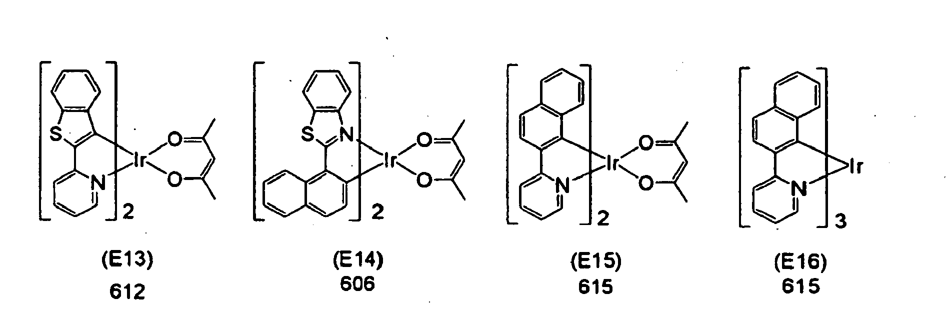 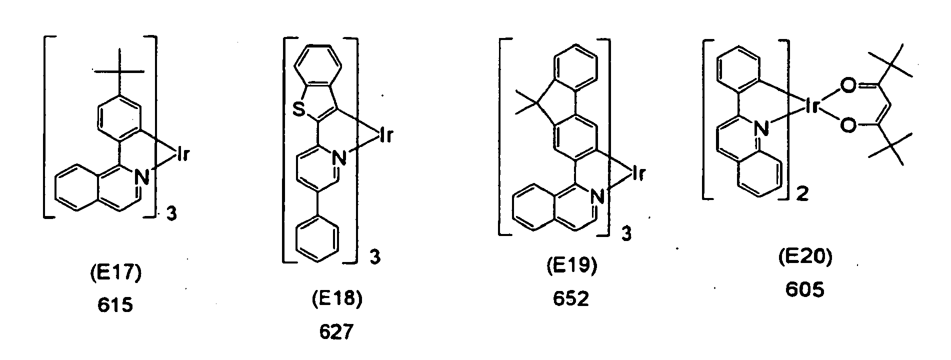 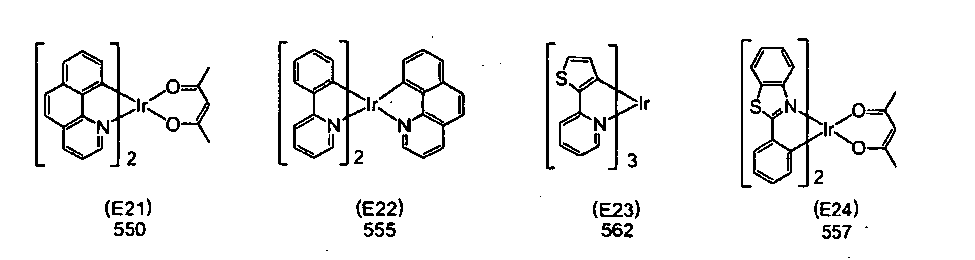 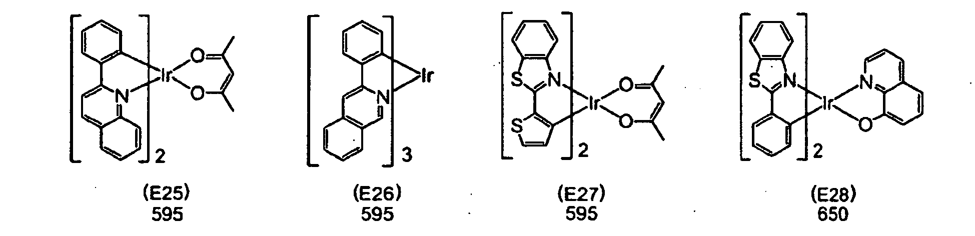 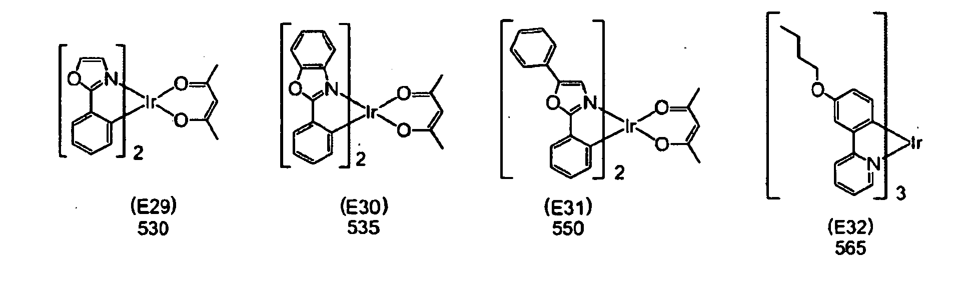 Each of the numbers appearing under the compound numbers in formulas (E1) through (E32) shows the maximum emission wavelength (λ_{em,max}) (nm) in a solid state excited by light of 460 nm.

Examples of iridium complex structures other than the above structures used in the present invention include the following E33 to E42.

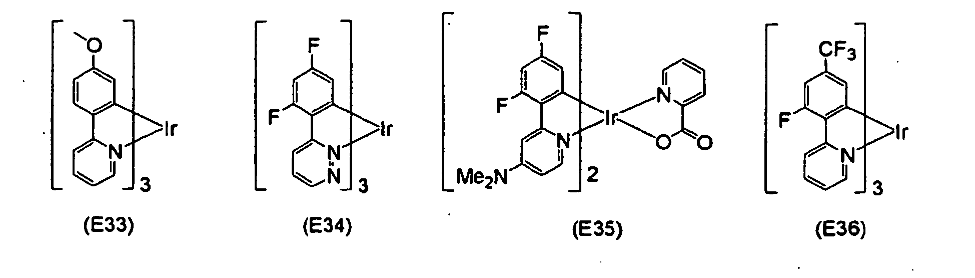

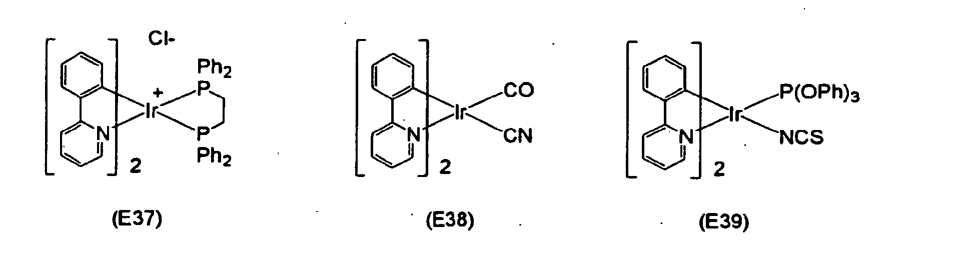

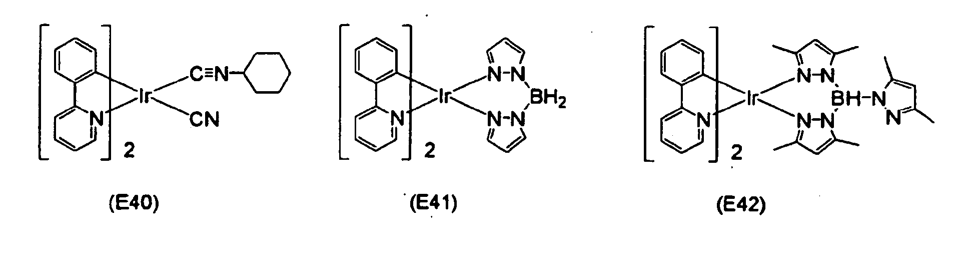

An iridium compound according to the invention can be readily obtained by means of a known method.

That is, typically, in an iridium complex shown by formula (2) 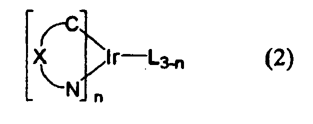 when n is 3, in other words, when the iridium complex is represented by the formula below, 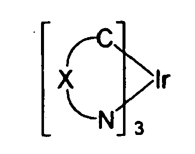 as shown by a scheme (1) below, the complex can be synthesized by heating an iridium tris(acetylacetonate) complex and a hydrogenated body (A) of a ligand in glycerol.

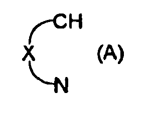

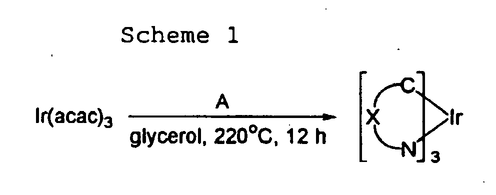

When n is 2, in other words, when the iridium complex is represented by the formula below, 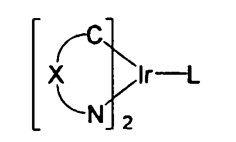 as shown in a scheme 2 below, the complex can be obtained by firstly heating an iridium chloride hydride and a hydrogenated body A of a ligand in an ethoxyethanol/water mixture solution and then reacting the reaction product with a hydrogenated body (LH) of a ligand (L) different from A.

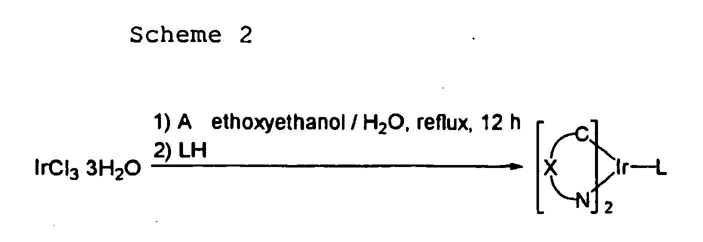

A method of illuminating the secondary luminescent unit with a primary luminescent unit to make the secondary luminescent unit emit is not particularly restricted. For instance, a method of dissolving or dispersing the iridium complex in a binder, spreading it on a transparent substrate by means of coating, spin coating or printing and delivering light emitted from the primary luminescent unit to the transparent substrate can be cited. Further, by adopting a method where the composition obtained by dissolving or dispersing an iridium complex in a binder is placed on the emission surface of the primary luminescent unit so as to cover the emission surface by means of coating or adhering, a secondary luminescent unit may be formed. The method of covering the emission surface of the primary luminescent unit is not particularly restricted. Existing methods such as a method of curing after dropping the composition onto the emission surface of the primary luminescent unit, printing/sealing method, dispenser method, molding method such as transfer molding and injection molding, and a coating method such as spin coating may be employed. According to these methods, formation and casting of lenses or formation of resin into plate-like forms can be carried out.

The secondary luminescent unit formed either on a transparent substrate or on the emission surface of the primary luminescent unit to cover the surface may consist of multiple layers including a layer of iridium compound-containing composition. In this case, the compositions forming the layers may be the same or different from each other, and furthermore the layer containing an iridium complex is not restricted. For instance, a composition containing an iridium complex may become the first layer and another composition not containing iridium complex may become the second layer. Conversely, a composition not containing an iridium complex may become the first layer and another composition containing an iridium complex may become the second layer. Further, a composition not containing an iridium complex may become the first layer, another composition containing an iridium complex may become the second layer and still another composition not containing an iridium complex may become the third layer. However, it is preferable that the outermost layer be a composition not containing an iridium complex.

In the present invention, the binder in which the iridium complex is dissolved or dispersed is not particularly restricted. Examples thereof include heat-curable resins, photo-curable resins, thermoplastic resins, resins radically polymerizable by heat and water-soluble resins.

It is preferable that the light transmittance of the resin used as a binder be 50% or more in a wavelength region of 400 to 800 nm, more preferably 80% or more.

When a lamp-type(bombshell-like shape), a top-view or a side-view type lighting device is prepared, the heat-curable and photo-curable resins are preferable because casting method can be employed in the production process.

A lamp-type lighting device can be prepared by casting a resin having the iridium complex of the invention dissolved or dispersed therein into a mold, introducing a lead frame mounted with an LED chip into the resin and then curing. Furthermore, similarly, a top-view or side-view-type lighting device can be prepared by casting a resin having the iridium complex of the invention dissolved or dispersed therein into the inside of a casing where an LED chip is wired.

As the heat-curable resin, from a viewpoint of the transparency in a wavelength range of 400 to 800 nm, an epoxy resin, a silicone resin and a resin radically polymerizable by heat are preferable.

Examples of epoxy resin include glycidyl ether type, glycidyl ester type, glycidyl amine type, alicyclic type, aliphatictype, distillates and hydrogenated resins of these types, and further epoxy acrylates. Examples of glycidyl ether type epoxy resin include bifunctional epoxy resins such as bisphenol A type epoxy resin, hydrogenated bisphenol A type epoxy resin, bisphenol F type epoxy resin, hydrogenated bisphenol F type epoxy resin, brominated bisphenol A type epoxy resin, bisphenol S type epoxy resin, bisphenol AD type epoxy resin, biphenyl type epoxy resin, naphthalene type epoxy resin and fluorene type epoxy resin and polyfunctional epoxy resins such as phenol novolak type epoxy resin, o-cresol novolak type epoxy resin, DPP novolak type epoxy resin, tris-(hydroxyphenyl) methane type epoxy resin and tetraphenylol ethane type epoxy resin. Furthermore, examples of alicyclic epoxy resin include alicyclic diepoxy acetal, alicyclic diepoxy adipate, alicyclic diepoxy carboxylate and vinylcyclohexane dioxide. Other than the above, triglycidyl isocyanate type epoxy resin and a hydantoin epoxy resin can be cited. In particular, epoxy resins of glycidyl ether type, alicyclic type and aliphatic type and distillates or hydrogenated resins thereof are preferred.

Excessively high viscosity of the epoxy resin deteriorates compatibility between the resin and the iridium complex of the invention and therefore, it is preferable to use a liquid epoxy resin having a low viscosity of about 50,000 cps or less, more preferably about 5,000 cps or less (BH type viscometer) can be preferably used.

In consideration for UV rays, though only in a slight amount, generated from a gallium nitride compound semiconductor, it is preferable to use a sealing resin unsusceptible to UV rays. The above epoxy resins are preferable in that the epoxy resins are unsusceptible to UV rays. Among these, glycidyl ether type epoxy resins are preferable. Particularly preferred are hydrogenated bisphenol A type epoxy resin, hydrogenated bisphenol F type epoxy resin and alicyclic epoxy resin. Hydrogenated bisphenol A type epoxy resin and hydrogenated bisphenol F type epoxy resin are preferred in that these are unsusceptible to UV rays and excellent in the light transmittance. One of the epoxy resins can be used singly or two or more of them may by used in combination.

In order to cure the epoxy resins, usually a curing agent and when appropriate, a curing accelerator are added. The curing agent is not particularly limited, and for instance, a liquid colorless acid anhydride or the like can be used. Examples of liquid colorless acid anhydride include phthalic anhydride, maleic anhydride, trimellitic anhydride, pyromellitic anhydride, hexahydrophthalic anhydride, tetrahydrophthalic anhydride, methylnadic anhydride, nadic anhydride and glutaric anhydride, and particularly preferred are those sufficiently purified and less-colored. It is preferable that the addition amount of the curing agent be in the range of about 60 to 120 % and particularly preferably in the range of about 80 to 110 %, based on an epoxy equivalent of the epoxy resin. When the amount of the curing agent is too small, an uncured portion is generated in the epoxy resin composition. Furthermore, when the amount of the curing agent added is excessive, the epoxy resin composition itself becomes hygroscopic, which is detrimental to the curing characteristics. If the amount of the curing agent is within the above-mentioned range, such problems are not caused.

As the curing accelerator, for instance, imidazoles, triphenyl phosphines, tributyl phosphines or salts thereof, DBU (diazabis-cycloundecene), tertiary amines and metal salts of carboxylic acids can be used. It is preferable that the addition amount of the curing accelerator be in the range of about 0.001 to 50 % by mass and particularly preferably in the range of about 0.01 to 10 % by mass based on the amount of the curing agent.

As commercially available ones, EL-308 and 438 (product codes, manufactured by Sanyu Rec Co., Ltd.) and ME-561/HV-560 (product codes, manufactured by Nippon Pelnox Corp.) that are on the market as casting materials of LEDs can be used.

Furthermore, in place of the curing agent and the curing accelerator, a curing catalyst such as a cationic polymerization catalyst can be used. Onium salts of Bronsted acid such as aromatic diazonium salts (HPF₆, HSbF₆ and so on), aromatic sulfonium salts and aromatic iodonium salts; iron aromatic compound salts of Bronsted acid; and aluminum complex/photo-destructive silicon compound catalysts, all of which generate an acid upon heating, can be used for curing. As commercially available products, for instance, CP-66 and CP-67 (product codes: manufactured by Asahi Denka Kogyo K.K.), CI-2855 andCI-2639 (product codes: manufactured by NIPPON SODA Co., Ltd.) and SI-60 and SI-100 (product codes: manufactured by SANSHIN CHEMICAL INDUSTRY Co., Ltd.) can be cited. As the acid-generating cationic polymerization initiator, one of the above compounds can be used singly or two or more of themmay be used in combination.

As silicone resins, phenyl silicone resins, epoxy silicone resins, phenyl silicone rubbers, methyl silicone rubbers and methyl silicone resins can be cited.

As commercially available ones, XJL-0001A/B (product code: manufactured by Nippon Pelnox Corp.) and KER-2667, X-32-2379-4 and X-32-2480-1 (product codes: manufactured by Shin-Etsu Chemical Co., Ltd.) that are on the market as casting materials for LEDs can be used.

The resin radically polymerizable by heat is not particularly restricted. Existing radical polymerizable monomers having a radical polymerizable unsaturated bond or a (meth)acryl group can be used. In general, resins such as poly-functional epoxy (meth)acrylate resin, poly-functional urethane (meth) acrylate resin and unsaturated polyester, diluted with a reactive diluent to have a desired viscosity, are used.

Examples of the reactive diluent include mono-functional (meth)acrylate compounds such as methyl (meth)acrylate, ethyl (meth) acrylate, n-propyl (meth)acrylate, n-butyl (meth)acrylate, 2-ethylhexyl (meth)acrylate, lauryl (meth)acrylate, cyclohexyl (meth)acrylate, phenoxyethyl (meth)acrylate, 2-ethoxyethyl (meth)acrylate, glycidyl (meth)acrylate, 2-hydroxyethyl (meth)acrylate, benzyl (meth)acrylate and ethylene glycol mono(meth)acrylate; ethylene glycol di(meth)acrylate, polyethylene glycol di(meth)acrylate, trimethylolpropane tri(meth)acrylate, pentaerythritol tetra(meth)acrylate and dipentaerythritol penta(meth)acrylate.

As a heat radical polymerization initiator for smoothly accelerating the heat radical polymerization, any existing initiator that generates a radical upon heating can be used. Examples thereof include organic peroxides and azo base initiators.

As the photo-curing system, a photo-cation polymerization system and a photo-radical polymerization system can be used.

In the photo-cation polymerization system, curing can be carried out by using an initiator generating an acid by irradiation of active energy rays such as UV ray in place of the initiator generating an acid upon heating as above described in relation to epoxy resin.

Examples of the initiator commercially available include SP-150 and SP-170 (product codes, manufactured by Asahi Denka Kogyo Co., Ltd.), CYRACURE-UVI-6990 and UVI-6974 (trade name, manufactured by Union Carbide Corporation), (2, 4-cyclopentadiene-1-yl) [(1-methylethyl)benzene]-Fe (II)hexafluorophosphate) and RHODORSIL 2074 (trade name, manufactured by Ciba Specialty Chemicals Inc.) and 4-methylphenyl-4-(1-methylethyl)phenyl iodonium tetrakis (pentafluorophenyl)borate) (manufactured by Rohne-Puolenc Corporation).

One of these acid-generating cationic polymerization initiators may be selected to be used singly or two or more of them may be used in combination.

A composition including the resins, initiators and so on is cast into a casing, followed by irradiation of active energy rays in the range of about 0.001 to 10 J to thereby cure the composition.

The photo-radical polymerizable resin is not particularly restricted. Materials above described in relation to the heat-radical polymerizable resins can be used.

As the photo-radical polymerization initiator for smoothly accelerating the photo-radical polymerization of a compound having a radical lypolymerizable unsaturatedbond or a (meth) acryl group, existing known compounds that are responsive to light to generate a radical can be used. The term "light" here means radiation such as visible ray, UV-ray, far-UV ray, X-ray or electron beam. Examples of the photo-radical polymerization initiator linclude benzoin, benzoin ethyl ether, benzoin isopropyl ether, benzoin-n-butyl ether, benzoin isobutyl ether, acetophenone, dimethylaminoacetophenone, 2, 2-dimethoxy-2-phenylacetophenone, 2, 2-diethoxy-2-phenylacetophenone, 2-hydroxy-2-methyl-1-phenylpropane-1-one, 1-hydroxycyclohexylphenyl ketone, 2-methyl-1-[4-(methylthio)phenyl]-2-morpholinopropane-1-one (Irgacure 907: trade name, manufactured by Ciba Specialty Chemicals Inc.), 4-(2-hydroxyethoxy)phenyl-2-(hydroxy-2-propyl)ketone, benzophenone, p-phenylbenzophenone, 4, 4'-diethylaminobenzophenone, dichlorobenzophenone, 2-methylanthraquinone, 2-t-butylanthraquinone, 2-aminoanthraquinone, 2-methylthioxanthone, 2-ethylthioxanthone, 2-chlorothioxanthone, 2, 4-diethylthioxanthone, benzyldimethylketal, p-dimethylaminebenzoic acid ester, 2, 4, 6-trimethylbenzoyldiphenylphosphine oxide (trade name: Lucerin TPO, manufactured by BASF AG), bis(2, 6-dimethoxybenzoyl)-2, 4, 4-trimethyl-pentylphosphine oxide-containing initiators (trade names: Irgacure 1700, 149 and 1800, manufactured by Ciba Specialty Chemicals Inc.) and bis(2, 4, 6-trimethylbenzoyl)-phenylphosphine oxide (trade name: Irgacure 819 manufactured by Ciba Specialty Chemicals Inc.). One of these initiators may be used singly or two or more of them may be used in combination.

The amount of the photo-radical polymerization initiator used is, based on 1 equivalent of (meth) acryl of a compound having a radically polymerizable unsaturated group in the composition, in the range of 0.007 to 0.5 mol and preferably in the range of 0.035 to 0.3 mol. When the addition amount of the photo-radical polymerization initiator is less than 0.007 mol, the sensitivity becomes insufficient. On the other hand, even when the addition amount exceeds 0.5 mol, further improvement in the sensitivity can not be obtained and it is economically disadvantageous.

A composition including the resins, initiator and so on is cast into a casing, followed by irradiation of active energy rays in the range of substantially 0.001 to 10 J to thereby cure the composition.

In a light-emitting device wherein light is emitted from a gallium nitride compound semiconductor provided with electrodes when a voltage is applied thereon and the light is converted into light of a variety of wavelengths by use of an iridium complex, the resin in which the iridium complex is dispersed can be used as a wavelength converting plate or a wavelength converting sheet disposed at a distance from the gallium nitride compound semiconductor.

The shape and size of the wavelength converting plate or sheet are not particularly restricted. When it is formed planar, lightingof surface emission can be obtained, which can be utilized as backlight in non-luminescent displays such as liquid crystal display. When it is formed into lens-like shape, it can be used as a lamp of a projector or the like.

The resin that is used to prepare the wavelength converting plate or sheet is not particularly restricted. However, it is preferable to use those having light transmittance of 50% or more in a wavelength region of 400 to 800 nm, more preferably 80% or more.

As the resin, any one of thermoplastic resin, heat-curable resin, resin radically polymerizable by heat and a photo-curable resin can be used. However, when it is processed into a plate, it is advantageous to use a thermoplastic resin. When the thermoplastic resin is used, iridium complex is dispersed or dissolved in the resin by use of a suitable kneader such as a twin-screw mixer Labo Plastomill, followed by extrusion-molding, injection-molding or press-molding to thereby obtain a target wavelength converting plate or sheet.

Furthermore, when heat-curable resin is used as well, by use of a similar suitable kneader, the iridium complex of the present invention is dispersed or dissolved in the resin, cast into a mold with a desired thickness and cured by heating, to thereby obtain a wavelength converting plate or sheet.

Examples of the heat-curable resins usable here include the epoxy resins, the silicon resins and the heat-radical resins that were aforementioned in relation to preparation of the lamp type-, top view type- and side view type- lighting devices.

Examples of the thermoplastic resins include olefin base resins (polyethylene, polypropylene, ethylene/vinyl acetate resins, ethylenevinyl alcohol resins,polymethylpentene, cyclic olefin copolymers, chlorinated polyethylene and chlorinated polypropylene), vinyl chloride base resins (polyvinyl chloride, ethylene/vinyl chloride resins, chlorinated polyvinyl chloride and polyvinylidene chloride), styrene base resins (polystyrene, styrene/acrylonitrile resins, ABS resins, AAS resins, AES resins, ACS resins, MBS resins, styrene/N-phenyl maleimide resins and styrene/maleic anhydride resins), polymethacrylate resins (PMMA), polyamide base resins, thermoplastic polyesters (PET, PBT, PEN and PBN), polyacetal resins, polycarbonate resins, modified phenylene ether resins, polyphenylene sulfides, polyacrylate resins, ketone base resins and sulfone base resins, all of which are described in *Polymer Material Guide Book '97* (Japan High Polymer Material Center, October, 1997). One of the thermoplastic resins may be used singly or two or more of them may be used as polymer alloys.

Further examples thereof include isoprene rubber, ethylene/propylene rubber, acrylic rubber, urethane rubber, silicone rubber, olefin base thermoplastic elastomer, styrene base thermoplastic elastomer, vinyl chloride base thermoplastic elastomer, urethane base thermoplastic elastomer, polyester base thermoplastic elastomer and polyamide base thermoplastic elastomer.

Furthermore, water-soluble resins such as polyethylene glycol, polyvinyl alcohol, methyl cellulose, polyacrylic acid, aqueous polyester, aqueous urethane resin, melamine resin, polyethylene oxide, polyvinyl pyrrolidone, aqueous acrylic resin, aqueous alkyd resin and maleic resin may be used as well.

Preferred among these are PMMA, MMA/styrene copolymer, polycarbonate resin, transparent ABS resin, polystyrene resin, polyarylate resin, polysulfone resin, polyolefin base resin (trade name: Arton manufactured by JSR and trade name: ZEONEX manufactured by Nippon Zeon Co., Ltd.), CR-39 (diethylene glycol bisallylcarbonate) resin and transparent nylon resin, which exhibit high light transmittance in the range of 400 to 800 nm.

As specific examples of the photo-curable resins, the photo-cation cured type resins and photo-radical cured type resins as above described in relation to preparation of lamp type, top-view type or side-view type lighting device can be used.

Furthermore, in preparation of a lamp-type, top-view- or side-view-type lighting device or a wavelength converting plate or sheet by using a thermoplastic resin, it is possible to prepare the device, sheet or plate by dissolving the resin in a solvent, dropping it at a desired position or filling and then drying the solvent (dissolution dispersion method) to seal.

As the solvent, those that can dissolve or disperse the film-forming resin component can be used. Examples of the solvent include hydrocarbon base solvents such as toluene, xylene and high boiling point petroleum hydrocarbons; ketone base solvents such as methyl ethyl ketone, methyl isobutyl ketone, cyclohexanone and isophorone; ester base solvents such as ethyl acetate, butyl acetate, ethylene glycol monoethyl ether acetate and diethylene glycol monoethyl ether acetate; alcohol base solvents such as methanol, ethanol and butanol; and ether/alcohol base solvents such as ethylene glycol monoethyl ether, ethylene glycol monobutyl ether and diethylene glycol monobutyl ether. One of these solvents may be used singly or two or more of them may be used as a mixture.

Furthermore, for the purpose of controlling an emission wavelength and chromatic coordinates, other organic fluorescent substance, inorganic fluorescent substance, pigment and the like may be contained in lamp-type, top-view-type or side-view-type lighting device and a wavelength converting plate or sheet according to the invention, within a range where light emission by the iridium complex of the invention may not be disturbed.

Still furthermore, in the resin composition used in the lighting device according to the invention, additives such as a UV absorber, light stabilizer and antioxidant maybe added within a range where light emission by the iridium complex is not disturbed.

UV absorber and light stabilizer are added to obtain light resistance. Examples of UV absorber include benzophenone UV absorber, benzotriazole UV absorber, triazine UV absorber, cyanoacrylate UV absorber, salicylate UV absorber, benzoate UV absorber, oxalic acid anilide UV absorber and inorganic UV absorber such as sol-gel. Furthermore, compounds obtained by copolymerizing these UV absorbers can be preferably used as well.

As the light stabilizer, existing ones, as typified by hindered amine light stabilizer, can be used.

Furthermore, in a range that does not disturb effects of the invention, various kinds of additives can be appropriately added to the resin composition. Examples of additives include heat resistant stabilizers, hindered phenols and phosphorus antioxidants, organic lubricants, fluidity-controlling agents and adhesiveness-imparting agents such as silane coupling agents. Examples of the silane coupling agent include KBM303, KBM403 and KBM402 (product codes: manufactured by Shin-Etsu Silicone Co., Ltd.).

Still furthermore, when necessary, existing known additives such as silicone-based, fluorinated or polymer-based defoaming agent; leveling agent; silicone-based or acrylic pigment-dispersing agent; flame retardents such as antimony trioxide, bromo compound, phosphate ester, red phosphorus and nitrogen-containing compound such as melamine resin; and a stress relaxation agent such as silicone oil and silicone rubber powder can be used. Furthermore, in order to impart wide directivity, a diffusing agent such as calcium carbonate, resin beads and spherical silica may be contained to diffuse light.

A method of manufacturing the light-emitting device according to the invention includes a step of obtaining a composition by adding an iridium complex into a binder followed by mixing through stirring; a step of covering a gallium nitride compound semiconductor with the medium containing the iridium complex; and a step of fixing the medium containing the iridium complex.

When the binder is, for instance, an epoxy resin, the manufacturing method includes a step of obtaining a composition by adding an iridium complex to an epoxy resin followed by mixing through stirring; a step of covering a gallium nitride compound semiconductor with the epoxy resin containing the iridium complex; and a step of curing the epoxy resin containing the iridium complex.

The method of adding an iridium complex to an epoxy resin and mixing the resin composition through stirring is not particularly restricted; however, the step can be carried out by mixing the resin composition with a shaker at room temperature. At this time, the process may be carried out under heating. The mixture may be heated to a temperature lower than the curing temperature for a short time, or after the mixing of the base material resin (so-called main ingredient) alone, a curing agent may be added.

It is preferable that the binder thus obtained containing iridium complex be deaerated before the subsequent steps. Deaerating method is not particularly restricted. For instance, deaeration can be carried out by placing the binder containing iridium complex in a desiccator and maintaining it under reduced pressure for 10 to 300 minutes.

Although the mixing ratio of the iridium complex to the binder depends on uses, usually it is preferable that the ratio of the iridium complex be in the range of 0.001 to 30 % by mass and more preferably in the range of 0.01 to 10 % by mass.

In most cases, fixing (curing) step can be carried out by heating. However, curing conditions are different depending on the kind of the medium used. For instance, in the case of an epoxy resin, the curing is usually carried out preferably at a temperature in the range of about 60 to 180 °C for about 30 to 600 minutes and particularly preferably at a temperature in the range of about 80 to 150 °C for about 60 to 300 minutes. Curing may be carried out under atmospheric air or nitrogen atmosphere ; nitrogen atmosphere is preferred.

The light-emitting device according to the invention may be further coated with CVD carbon, SiO₂ or the like.

A vessel, package or casing that is used in the invention to contain the iridium complex and the medium is not particularly restricted. For instance, a top-view type package or a side-view type package system manufactured by TOYODEMPA Co., Ltd. can be used. The vessel and package may be coated in advance with CVD carbon, SiO₂ or the like.

When a thermoplastic resin is used, the resin and the iridium complex can be mixed by use of a known mixing device. As the mixing device, as far as it can uniformly mix the respective raw materials, there is no particular restriction. Specifically, a kneader, a three-roller mill and a biaxial Labo Plastomill can be cited. The iridium complex according to the present invention is dispersed or dissolved with the kneader, followed by molding by use of an extrusion molding machine, injection molding machine or a pressing machine, and thereby target wavelength converting plate or sheet can be obtained.

The method of melt kneading is not particularly restricted. For example, a mixture obtained by lightly mixing in advance pellets of a PMMA resin and an iridium complex may be kneaded by use of a mill under heating in a nitrogen atmosphere, or an iridium complex may be added into a resin molten in a mill.

A melting temperature depends on the softening temperature of a resin used. In the case of polyethylene, polypropylene, PMMA and polystyrene being used, a temperature in the vicinity of 180°C is preferable. When the resins are melted and kneaded at a temperature exceeding 220 °C, coloration of the resin and deterioration of the iridium complex may be unfavorably caused. Furthermore, a melting and kneading time is preferably set in the range of several seconds to one hour or less in the proximity of the temperature.

As molding method, a method where kneaded resin composition in block as it is or in pellet form once taken out is molded under heating by use of a press machine to obtain a plate or sheet is convenient. A method where the melt-kneaded resin is directly molded is more preferable. In particular, when a molding method such as the injection molding or extrusion molding is adopted, a complicated shape can be molded and since the melt kneading and molding can be continuously carried out, the production efficiency can be increased.

As a kneader used when a thermosetting resin is used, similarly, an agitator provided with a suitable mixing blade, a mixing kneader, a paint shaker, a kneader, and a three-roller mill can be cited. The kneader is selected therefrom in consideration for the viscosity of the composition and used to disperse or dissolve the iridium complex according to the present invention in the resin, followed by charging into a mold set at a desired thickness, further followed by heating to cure.

When a photocurable resin is used, the photocurable resin, after kneaded in the same manner as above and charged into a light-transmissive mold, can be cured by irradiation of active energy such as UV ray.

Generally, the ratio of mixing, dispersing or dissolving an iridium complex to a resin which is, different depending on applications thereof, is preferably in the range of 0.001 to 30 % by mass, and more preferably in the range of 0.01 to 10 % by mass.

In a lighting system, light generated when a voltage is applied from electrodes to a gallium nitride compound semiconductor chip is converted in color by use of the iridium complex and is radiated outside of the system.

In order to obtain a necessary emission color, the kind, the mixing ratio and the concentration of the iridium complex are controlled. A coloring agent may be added to apply a fine control of a color tone. As the coloring agent, the same agents as those used in general color filters can be used.

As the coloring agent that can be used in the present invention, either of dyes and pigments can be used. However, from viewpoints of the heat resistance and the light resistance, the pigments are preferable. As the pigments, organic one and inorganic one may be both used. As the organic pigments, for instance, red pigments such as C.I. Pigment Red 9, C.I. Pigment Red 97, C.I. Pigment Red 122, C.I. Pigment Red 123, C.I. Pigment Red 149, C.I. Pigment Red 168, C.I. Pigment Red 177, C.I. Pigment Red 180, C.I. Pigment Red 192, C.I. Pigment Red 215, C.I. Pigment Red 216, C.I. Pigment Red 217, C.I. Pigment Red 220, C.I. Pigment Red 223, C.I. Pigment Red 224, C.I. Pigment Red 226, C.I. Pigment Red 227, C.I. Pigment Red 228, C.I. Pigment Red 240, C.I. Pigment Red 254 and C.I. Pigment Red 48:1; green pigments such as C.I. Pigment Green 7 and C.I. Pigment Green 36; blue pigments such as C.I. Pigment Blue 15, C.I. Pigment Blue 15:6, C.I. Pigment Blue 22, C.I. Pigment Blue 60 and C.I. Pigment Blue 64; violet pigments such as C.I. Pigment Violet 19, C.I. Pigment Violet 23, C.I. Pigment Violet 29, C.I. Pigment Violet 30, C.I. Pigment Violet 37, C.I. Pigment Violet 40 and C.I. Pigment Violet 50; yellow pigments such as C.I. Pigment Yellow 20, C.I. Pigment Yellow 24, C.I. Pigment Yellow 83, C.I. Pigment Yellow 86, C.I. Pigment Yellow 93, C.I. Pigment Yellow 109, C.I. Pigment Yellow 110, C.I. Pigment Yellow 117, C.I. Pigment Yellow 125, C.I. Pigment Yellow 137, C.I. Pigment Yellow 138, C.I. Pigment Yellow 139, C.I. Pigment Yellow 147, C.I. Pigment Yellow 148, C.I. Pigment Yellow 150, C.I. Pigment Yellow 153, C.I. Pigment Yellow 154, C.I. Pigment Yellow 166, C.I. Pigment Yellow 168 and C.I. Pigment Yellow 185; and black pigments such as C.I. Pigment Black 7 can be cited. Furthermore, as the inorganic pigments, for instance, carbonbase, titanium base, barium base, aluminum base, calcium base, iron base, lead base, and cobalt base-inorganic pigments can be cited. The pigments can be used singularly or in a combination of at least two kinds.

In order to obtain a lighting device, light generated by the primary and secondary luminescent units needs to be radiated toward outside of the device.

In order to obtain a necessary emission color, the kind, mixing ratio and concentration of the iridium complex that is the secondary luminescent unit need to be controlled.

When a light-emitting body according to the invention is used as a backlight of a display device, the secondary luminescent unit is formed on the emission surface of the primary luminescent unit so that a desired light source color may be obtained, to thereby to form a lamp, and in accordance with a light amount required, the lamp is disposed. Alternatively, the primary luminescent unit and the secondary luminescent unit are spatially separated so that the two may be disposed in such a manner that light from the former can irradiate the latter or that light emitted by the former can be guided toward the latter by a light guide plate. In this case, it is preferable that the secondary luminescent unit be formed on a transparent body so that light emitted from the light source of the primary light-emitting may enter the secondary luminescent unit and moreover, in order for light from the primary luminescent unit to uniformly illuminate an iridium complex in the secondary luminescent unit, it is preferable that the complex be formed in layer form on the transparent body.

Furthermore, by forming the secondary luminescent unit as pixels made of three primary colors, a self-luminous type display can be configured. That is, on a transparent substrate, iridium complexes that emit in red, green and blue are separately spread in stripes or in matrix, to thereby form pixels. Between the primary and secondary luminescent units, light valves capable of controlling pixel by pixel are disposed, and through opening/closing of the light valves, desired pixels are turned on/off, to thereby form an image. As the light valve, a liquid crystal panel and a digital mirror device can be cited. Furthermore, when a blue light-emitting diode is used as the primary luminescent unit, a blue light-emitting body is not used and on the transparent substrate, the portion for blue light-emitting body is left uncoated to thereby let light from the light source pass as it is.

Next, planer light-emitting device is specifically explained.

Recently, emission efficiency of light-emitting diode device has been remarkably improved and its application to illumination is being developed. Particularly, in case of using light-emitting diode as light source for backlight in liquid crystal display, excellent color-reproducibility and quick response can be realized and further, achievement of high image quality is expected. Light source for backlight usually introduces light into a light guide by arranging light-emitting diodes placed in separate packages in line and lighting the edge surface of the light guide. Then, a diffusion reflector plate provided on one side of the light guide emits light toward the other side, thereby a constituting a planar light-emitting device.(See "Monthly Display", Vol.9, No.4, Page 33, published Techno Times Co., Ltd., 2003).

In a direct type backlight, light-emitting diode elements are arranged in a matrix on a planar reflector, and placed thereon is a diffuser plate for equalizing light, thereby constituting a planar light-emitting device. (See "LCD-you furonto bakkuraito no shintennkai" (new developments on front-and back-lights for LCD), published by TORAY RESEARCH CENTER, Inc., 2002).

The light-emitting body of the present invention can be applied in such a planer light-emitting device. The planer light-emitting device of the present invention comprises multiple primary luminescent units, secondary luminescent units which are excited by light emitted by the primary luminescent units to emit light, a light guide plate, a reflector plate and a diffuser plate, and the secondary luminescent units contain iridium complexes. It is preferable that the above-described light-emitting diodes be used as the primary luminescent units.

As members constituting the planar light-emitting device of the present invention, primary luminescent unit consisting of light-emitting diodes, secondary luminescent units which are excited by light emitted by the primary luminescent units to emit light, a light guide plate, a reflector plate and a diffuser plate (light-scattering plate) can be mentioned.

The light-emitting diode element used in the planar light-emitting device may be selected according to the use of the planar light-emitting device. It is preferable to use a light-emitting diode element which can express a good white color as light source for backlight in a liquid crystal display. Preferred examples of light source for backlight include a combination of a recently-developed blue LED with conventional red and green LEDs, a combination of a blue LED and a photoluminescent material (secondary luminescent unit) which is excited by the blue LED emission and emits light of complementary blue and a combination of a ultraviolet LED and a photoluminescent material (secondary luminescent unit) which emits lights of red, green and blue. Examples of such a photoluminescent material include inorganic fluorescent materials such as (YaGd₁₋ₐ)₃(Al_{b},Ga_{1-b})₅O₁₂ : Ce (YAG fluorescent body), Y₂O₂S:Eu³⁺, (ZnS:Cu,Al) and (Sr,Ca,Ba,Mg)₁₀(PO₄)₆Cl₂:EU²⁺, organic fluorescent materials such as coumarin and rhodamine, and phosphorescent materials such as iridium complex

Particularly preferred as light source for backlight is a combination of a blue LED and a photoluminescent material (secondary luminescent unit) which is excited by emission of the blue LED and thereby emits lights of red and green. According to method using this combination, by controlling a single LED, good white light can be expressed and since the method uses blue light, it is free from deterioration of the constituent materials due to ultraviolet ray. Examples of photoluminescent material to be used in the combination include iridium complex compounds represented by the aforementioned formulae (E1) to (E32).

In the present invention, the photoluminescent material (secondary luminescent unit) may be used independently or may be used dissolved or dispersed in a binder as described below. The photoluminescent material (secondary luminescent unit) may be placed in any position of the constituents as far as light emitted from the LED light source can irradiate the material. However, it is preferable that the material be applied together with the binder to coat the surface of the LED element, that the material be applied onto the emission surface of the diffuser plate by a method such as coating or printing, or that the material be mixed in, dissolved or dispersed into the inside of the diffuser plate.

The binder may be any binder that the above complex can be dissolved or dispersed in and generally, a thermosetting resin is used. Examples of such a thermosetting resin include polycarbonate, polyethersulfone, polyacrylate, acrylic resin, polyvinylacetal, epoxy resin, cyanate resin, phenol resin, polyimide, polyurethane and silicone resin. Preferred among these is a transparent epoxy resin for its high transparency, and excellent usefulness including its adhesion property.

Examples of transparent epoxy resin include those obtained by curing an epoxy resin such as bisphenol A diglycidyl ether, 2,2-bis(4-glycidyloxycyclohexyl)propane, 3,4-epoxycyclohexylmethyl-3,4-epoxyhexanecarboxylate, vinylcyclohexenedioxide, 2-(3,4-epoxycyclohexane)-5,5-spiro-(3,4-epoxycyclohexane)-1, 3-dioxane, bis(3,4-epoxycyclohexyl)adipate, 1,2-cyclopropanedicarboxylic acid bisglycidyl ester, triglycidyl isocyanurate, monoallyl diglycidyl isocyanurate or diallyl monoglycidyl isocyanurate with an acid anhydride such as hexahydrophthalic anhydride, methylhexahydrophthalic anhydride, trialkyl tetrahydrophthalic anhydride or hydrogenated methyl nadic anhydride. One of these epoxy resin may be used singly or two or more of themmay be used in combination.

Preferred examples of light guide plate include glass and transparent resins such as epoxy resin, acrylic resin and polycarbonate, and particularly preferred are acrylic resin and polycarbonate.

Examples of reflector plate include aluminum, mirror-finished or alumite-treated aluminum, white-coated aluminum and evaporated silver PET film, and further include white films such as white PET film, white polypropyrene film and white polycarbonate. Examples of white PET film include Lumirror 60L, Lumirror 60V, Lumirror 60SL and Lumirror 60SV manufactured by Toray Industries, Inc., and PP Reflector manufactured by Mitsui Chemicals, Inc. and MCPET manufactured by The Furukawa Electric Co., Ltd. Moreover, the white film may be one adhered to and supported by a support such as metal.

Examples of the diffuser plate include a transparent resin plate inside of which a material having a different refractive index from that of the transparent resin is mixed or dispersed and a transparent resin plate or film whose one surface or both surfaces is coated with a material having a different refractive index from that of the transparent resin. Examples of such a material having a different refractive index from that of transparent resin include inorganic fine particles such as calcium carbonate, barium sulfate and glass, and organic fine particles such as styrene resin and acrylic resin. Particularly preferred are organic fine particles.

In the planer light-emitting device, it is preferable that by closely adhering all the constituents to thereby integrate the constituents so that substantially no air can be present in the interfaces therebetween. Thus, energy consumption can be decreased by reducing loss of light during the process until light becomes flat surface light source.

When a backlight system using light-emitting diode as its light source comprises a mechanism where light emitted from the surface of the light-emitting diode element, which once goes to the air space, then enters into a light guide or a diffuser plate, due to the small refractive index of the air, reflection of light occurs in the interface between the emission surface and the air and therefore, it is impossible to highly efficiently obtain light from the light-emitting diode. Although usually a diffuser plate is placed on a light guide to thereby diffuse light, since in such a technique where a diffuser plate is simply put on a light guide or is simplyplaced in contact with a light guide, the adhesion between the two is insufficient, thereby allowing the presence of the air therebetween. Thus, reflection of light in the side of the light guide causes reduction of efficiency in obtaining light form the light guide.

By closely adhering all the constituents present in the light path from the emission surface of the light-emitting diode element to the emission surface of the planar light-emitting device to thereby integrate the constituents, the emission performance can be remarkably improved.

The planar light-emitting device having such a structure, excellent in light emission performance, is useful as light source for backlight. Also, by controlling the shape of the dents where the light-emitting diodes are placed in accordance with the refractive index of the adhesive agent to fill in, a planar light-emitting device having a more uniform brightness can be obtained.

These constituents are usually bonded to be integrated by using adhesive agent, however, in case where the constituents include thermoplastic resin, the constituents may be bonded through thermocompression.

As adhesive agent, those having a refractive index of 1.2 or higher are preferable, more preferred are transparent resins having a refractive index of 1.4 or more. Examples of such an adhesive agent include epoxy resin adhesive and acrylic resin adhesive.

Further, in cases where a metal plate such as aluminium plate is used as the reflector plate and a thermoplastic resin such as acrylic resin is used as the light guide plate, the metal plate can be thermocompressed to the light guide plate by heating. Furthermore, the diffuser plate may be bonded to the light guide plate by applying a coating material obtained by dispersing or dissolving organic fine particles consisting of acrylic resin or styrene resin in acrylic resin or polycarbonate onto the light guide plate through printing method or spin-coating method.

As a method of bonding the light-emitting diode to the light guide plate, a method wherein dents for light-emitting diodes to be placed in are provided on the edge surface of the light guide plate where light enters and the light-emitting diodes are placed in the dents and sealed with the above-described adhesive agent. Moreover, it is preferable that the refractive index of the adhesive agent used for the sealing be higher than that of the light guide plate, since efficiency of light entering into the light guide can be higher. It is more preferable that the shape of the cross-section of a light entrance face of the dent of the light guide is a gibbous form, since total reflection hardly occurs even when the light incident angle is small and unevenness in brightness can be little.

In cases as above, it is preferable that the secondary luminescent unit be prepared by dissolving or dispersing an iridium compound in an adhesive.

### EXAMPLES

Hereinafter, the invention will be more detailed with reference to examples. However, the invention is not restricted thereto.

Color coordinates x and y, brightness, color rendering index and luminous efficiency were measured by use of a spectra-radiometer (trade name: CS1000A, manufactured by Konica-Minolta Corp.).

### Example 1:

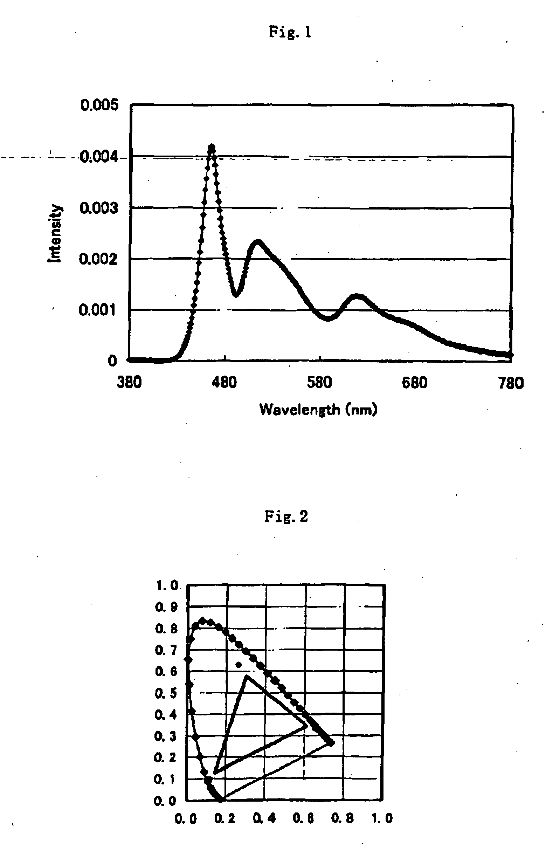

A secondary luminescent unit was prepared by adding 9 mg of an iridium complex (E2) and 1 mg of an iridium complex (E17) into a mixture of 5 g of bisphenol A diglycidyl ether and 5 g of methylhexahydrophthalic anhydride. After mixing the materials, the mixture was defoamed. Thus obtained mixture was poured into a recess portion of a cup of a lead frame in which a blue light-emitting diode serving as a primary luminescent unit was disposed and cured at 120°C for 1 hour. Furthermore, into a mold form for a lamp-type (bombshell type), amixture of bisphenol A diglycidyl ether and methylhexahydrophthalic anhydride was poured in advance, and then the lead frame was immersed, followed by curing at 120°C for 1 hour, to thereby prepare a lamp-type white LED. With respect to the obtained white LED, the x and y chromaticity coordinates, the color rendering index, the initial luminous efficiency and a decrease in the luminous efficiency after 100-hour operation were measured. Results thereof are shown in Table 1. An emission spectrum of the obtained white LED is shown in Fig. 1, and chromaticity coordinates of emissions of the blue light-emitting diode and iridium complexes for green and red lights which were excited by the blue light-emitting diode are shown in Fig. 2. A solid line (triangle) in Fig. 2 shows a color reproduction range of a liquid crystal display that uses an existing cold-cathode tube.

### Example 2:

A lamp-type LED was prepared in the same manner as in Example 1 except that 8.9 mg of a complex (E1) and 1.1 mg of a complex (E16) were used as the iridium complex. With respect to the obtained white LED, the x and y chromaticity coordinates, the color rendering index, the initial luminous efficiency and a decrease in the luminous efficiency after 100-hour hr operation were measured. Results thereof are shown in Table 1.

### Example 3:

A lamp-type LED was prepared in the same manner as in Example 1 except that 9.1 mg of a complex (E3) and 0.9 mg of a complex (E18) were used as the iridium complex. With respect to the obtained white LED, the x and y chromaticity coordinates, the color rendering index, the initial luminous efficiency and a decrease in the luminous efficiency after 100-hour hr operation were measured. Results thereof are shown in Table 1.

### Example 4:

A lamp-type LED was prepared in the same manner as in Example 1 except that 12 mg of a complex (E4) and 1 mg of a complex (E17) were used as the iridium complex. With respect to the obtained white LED, the x and y chromaticity coordinates x and , the color rendering index, the initial luminous efficiency and a decrease in the luminous efficiency after 100-hour hr operation were measured. Results thereof are shown in Table 1.

### Example 5:

A lamp-type LED was prepared in the same manner as in Example 1 except that 10 mg of a complex (E9) and 1 mg of a complex (E16) were used as the iridium complex. Of the obtained white LED, the x and y chromaticity coordinates, the color rendering index, the initial luminous efficiency and a decrease in the luminous efficiency after 100-hour hr operation were measured. Results thereof are shown in Table 1.

### Example 6:

A lamp-type LED was prepared in the same manner as in Example 1 except that 8.8 mg of a complex (E2) and 1.2 mg of a complex (E19) were used as the iridium complex. Of the obtained white LED, the x and y chromaticity coordinates, the color rendering index, the initial luminous efficiency and a decrease in the luminous efficiency after 100-hour hr operation were measured. Results thereof are shown in Table 1.

### Example 7:

A lamp-type LED was prepared in the same manner as in Example 1 except that 9 mg of a complex (E2) and 1 mg of a complex (E15) were used as the iridium complex. Of the obtained white LED, the x and y chromaticity coordinates, the color rendering index, the initial luminous efficiency and a decrease in the luminous efficiency after 100-hour hr operation were measured. Results thereof are shown in Table 1.

### Example 8:

A lamp-type LED was prepared in the same manner as in Example 1 except that 9 mg of a complex (E7) and 1 mg of a complex (E16) were used as the iridium complex. Of the obtained white LED, the x and y chromaticity coordinates, the color rendering index, the initial luminous efficiency and a decrease in the luminous efficiency after 100-hour operation were measured. Results thereof are shown in Table 1.

### Example 9:

A lamp-type LED was prepared in the same manner as in Example 1 except that 10 mg of a complex (E11) and 1 mg of a complex (E17) were used as the iridium complex. Of the obtained white LED, the x and y chromaticity coordinates, the color rendering index, the initial luminous efficiency and a decrease in the luminous efficiency after 100-hour operation were measured. Results thereof are shown in Table 1.

### Example 10:

A lamp-type LED was prepared in the same manner as in Example 1 except that 14 mg of a complex (E8) and 1.5 mg of a complex (E13) were used as the iridium complex. Of the obtained white LED, the x and y chromaticity coordinates, the color rendering index, the initial luminous efficiency and a decrease in the luminous efficiency after 100-hour hr operation were measured. Results thereof are shown in Table 1.

### Comparative example 1:

A lamp-type LED was prepared in the same manner as in Example 1 except that 4 mg of a green fluorescent dye HFG-4 (trade name, manufactured by Hayashibara biochemical laboratories Inc.) and 0.4 mg of a red fluorescent dye HFR-4 (trade name, manufactured by Hayashibara biochemical laboratories Inc.) were used in place of the iridium complex. Of the obtained white LED, the x and y chromaticity coordinates, the color rendering index, the initial luminous efficiency and a decrease in the luminous efficiency after 100-hour hr operation were measured. Results thereof are shown in Table 1.

**Table 1**

| | color coordinates (x,y) | color rendering property value | initial luminous efficiency (1m/W) | luminous efficiency after 100 hr operation (%) |
|---|---|---|---|---|
| Example 1 | 0.31,0.30 | 92 | 40 | 1 or less |
| Example 2 | 0.30,0.34 | 92 | 39 | 1 or less |
| Example 3 | 0.30,0.30 | 90 | 37 | 1 or less |
| Example 4 | 0.29,0.32 | 89 | 38 | 1 or less |
| Example 5 | 0.29,0.33 | 89 | 37 | 1 or less |
| Example 6 | 0.32,0.35 | 90 | 40 | 1 or less |
| Example 7 | 0.32,0.31 | 88 | 37 | 1 or less |
| Example 8 | 0.30,0.32 | 88 | 38 | 1 or less |
| Example 9 | 0.29,0.32 | 89 | 39 | 1 or less |
| Example 10 | 0.29,0.31 | 87 | 35 | 1 or less |
| Comparative Example 1 | 0.30,0.32 | 84 | 30 | 12 |

### Example 11:

1 g of an iridium complex (E2) and 100 mg of an iridium complex (E17) were mixed in 50 g of a transparent epoxy resin (manufactured by Sanyu Rec Co., Ltd.) and then defoamed. Subsequently, by using a wire bar, the mixture was spread to a thickness of about 0.1 mm on the inner surface of a cylindrical container made of an acrylic resin having a height of 150mm, an external diameter of 45 mm and an internal diameter of 40 mm and also on one surface of a circular disk made of an acrylic resin having a thickness of 5 mm, and curing treatment at 70°C for 6 hours was conducted. Then, the circular disk was adhered to the cylindrical container so that the circular disk formed the bottom surface of the cylindrical container. In this way, a secondary luminescent unit was obtained. A ultraviolet lamp having a whole length 145 mm and a maximum diameter of 50 mm (Neoball 5 black light manufactured by Toshiba Corporation.) was used as a primary luminescent unit, the light-emitting part of the lamp was placed in the secondary luminescent unit, and the lamp and the unit were adhered to each other at the points where the maximum diameter of the lamp contacted the unit by an epoxy resin. The color rendering index of the obtained light source for a lighting device was 90, the initial luminous efficiency was 36 lm/W and decrease in the luminous efficiency after 100-hour operation was 1 % or less.

### Example 12:

As an epoxy resin for dissolving an iridium complex, 2.0 g of a primary agent of ME561 manufactured by Nippon Pelnox Corp. and 2.0 g of a curing agent were mixed together. 20.0 mg of an iridium complex (E2) was added to the mixture, followed by shaking and mixing with a TEST TUBE MIXER manufactured by SHIBATA for 30 minutes. After pressure was reduced to defoam, two sheets of glass with a mold releasing film were distanced with a gap of 3 mm, followed by filling the gap therebetween with the resin composition, further followed by curing at 120°C for 1 hour. The obtained cured resin was cut into 3 mm x 3 mm x 3 mm, followed by fixing it on a top portion of a blue LED (XT12 manufactured by Cree Inc.) of 460 nm and 6.8 mW, and thereby a green color lamp was prepared. When the brightness of the lamp was measured, it was 27.4 lm/W and chromaticity coordinates were(x = 0.354, y = 0.607).

### Example 13:

As an epoxy resin for dissolving an iridium complex, 2.0 g of a primary agent of ME561 manufactured by Nippon Pelnox Corp. and 2.0 g of a curing agent were mixed together. 2. 64 mg of an iridium complex (E2) and 0.36 mg of an iridium complex (E17) were added to the mixture, followed by shaking and mixing with a TEST TUBE MIXER manufactured by SHIBATA for 30 min. After pressure was reduced to defoam, two sheets of glass with a mold releasing film were distanced with a gap of 3 mm, followed by filling the gap therebetween with the resin composition, further followed by curing at 120°C for 1 hour. The obtained cured resin was cut into 3 mm × 3 mm × 3 mm, followed by fixing it on a top portion of a blue LED (XT manufactured by Cree Inc.) of 460 nm and 6.8 mW, and thereby a white color lamp was prepared. When the brightness of the lamp was measured, it was 23.4 lm/W and chromaticity coordinates were (x = 0.315, y = 0.340).

### Example 14:

In 40 g of PMMA (trade name: PARAPET GH-100S, manufactured by Kuraray Co., Ltd.), 82 mg of an iridium complex (E2), 80 mg of a light stabilizer (trade name: Sanol LS770, manufactured by Sankyo Lifetec. Co., Ltd.) and 80 mg of an antioxidant (trade name: Irganox 1010, manufactured by Ciba Specialty Chemicals Co., Ltd.) were melt-kneaded under a nitrogen atmosphere with a biaxial laboplastomill at 180°C for 5 minutes.

Subsequently, the resin composition was formed into a sheet having a thickness of 1 mm by use of a press machine under a pressure of 4.9 × 10⁶ kPa at 180°C. The obtained sheet was cut into 3 mm × 3 mm × 1 mm, followed by fixing it on a top portion of a blue LED (XT manufactured by Cree Inc. ) of 460 nm and 6.9 mW, and thereby a light green color lamp was prepared. When the brightness of the lamp was measured, it was 32.76 lm/W and chromaticity coordinates were (x = 0.262, y = 0.485).

### Example 15:

A sheet having a thickness of 1 mm was prepared in the same manner as in Example 14 except for using polystyrene having a molecular weight of 250000 in place of 40 g of PMMA.

The obtained sheet was cut into 3 mm × 3 mm × 1 mm, followed by fixing it on a top portion of a blue LED (XT manufactured by Cree Inc.) of 460 nm and 6.9 mW. When the brightness was measured, it was 33.36 lm/W and chromaticity coordinates were (x = 0.293, y = 0.590).

### Example 16:

8.2 mg of an iridium complex (E2), 1.8 mg of an iridium complex (E17) and 15 g of ME561 (trade name, manufactured by Nippon PelnoxCorp.) (AandBsolutions) weremixed, followed by defoaming, and thereby a liquid resin 1 was prepared.

The liquid resin 1 was charged with a dispenser in a recess of a top-view type package on which a blue light-emitting diode (XT manufactured by Cree Inc.) was disposed, cured at 120°C for 2 hr and further at 150°C for 2 hr, and thereby a white LED was prepared. The obtained white LED was measured on x and y chromaticity coordinates, a color rendering index, an initial amount of emission and an amount of emission after operation at 30 mA for 500 hours, and the results were (0.33, 0.34) for x and y chromaticity coordinates (x, y), 90 for the color rendering index, 5.1 mW for the initial amount of emission and 4.4 mW for the amount of emission after operation at 30 mA for 500 hours.

### Example 17:

As an epoxy resin for dissolving an iridium complex, EL438 (trade name, manufactured by Sanyu Rec Co., Ltd.) (A solution and B solution) was mixed together followed by defoaming to prepare a liquid resin 2.

Then, 8.2 mg of an iridium complex (E2) and 1.8 mg of an iridium complex (E17) were mixed with EL438 (trade name, manufactured by Sanyu Rec Co., Ltd.) (A solution and B solution), followed by defoaming to prepare a liquid resin 3.
(1) 1^{st} layer: The liquid resin 2 was poured with a dispenser into a recess of a top-view type package on which a blue light-emitting diode (XT manufactured by Cree Inc.) was disposed, followed by curing at 120°C for 2 hours and further at 150°C for 2 hours.
(2) 2^{nd} layer: On the first layer, the liquid resin 3 was poured by use of a dispenser, followed by curing at 120°C for 2 hours and further at 150°C for 2 hours.
(3) 3^{rd} layer:On the second layer, the liquid resin 2 was poured by use of a dispenser, followed by curing at 120°C for 2 hr and further at 150°C for 2 hours, and thereby a white LED was prepared.

The obtained white LED was measured x and y chromaticity coordinates, the color rendering index, an initial amount of emission and an amount of emission after operation at 30 mA for 500 hours, and the results were (0.33, 0.34) for chromaticity coordinates (x, y), 90 for the color rendering index, 5.1 mW for the initial amount of emission and 4.9 mW for the amount of emission after operation at 30 mA for 500 hours.

### Example 18:

With the liquid resins 2 and 3 used in Example 17, 1^{st} and 2^{nd} layers were similarly manufactured.

A top-view type package coated with two layers was further coated with CVD carbon by use of PED350 (trade name, manufactured by ANLVA Corp.), and thereby a white LED was prepared. Deposition conditions of the CVD carbon were as follows.
CH₄ gas flow rate: 100 sccm
Film-formation pressure: 6 Pa
Bias power: 150 W
Film-formation time period: 10 min and
Film-formation temperature: room temperature

The obtained white LED was measured on x and y chromaticity coordinates, the color rendering index, an initial amount of emission and an amount of emission after operation at 30 mA for 500 hours, and the results were (0.33, 0.33) for chromaticity coordinates (x, y), 89 for the color rendering index, 4.7 mW for the initial amount of emission and 4.6 mW for the amount of emission after operation at 30 mA for 500 hours.

### Example 19:

An iridium complex mixture similar to Example 1 was applied onto a light incident edge face of a backlight guide plate for a cellular phone display (manufactured by Yoshikawa Kasei KK), followed by curing at 120°C for 1 hour to form an iridium complex layer having a thickness of 10 µm, and thereby a secondary light-emitting body was obtained. Four surface-mounting type light-emitting diodes (trade name: NSCB215, manufactured by Nichia Chemical Corp.) having an emission peak wavelength at 460 nm were used as a primary luminescent unit and disposed, according to a conventional method, on an edge face of a light guide plate to emit.

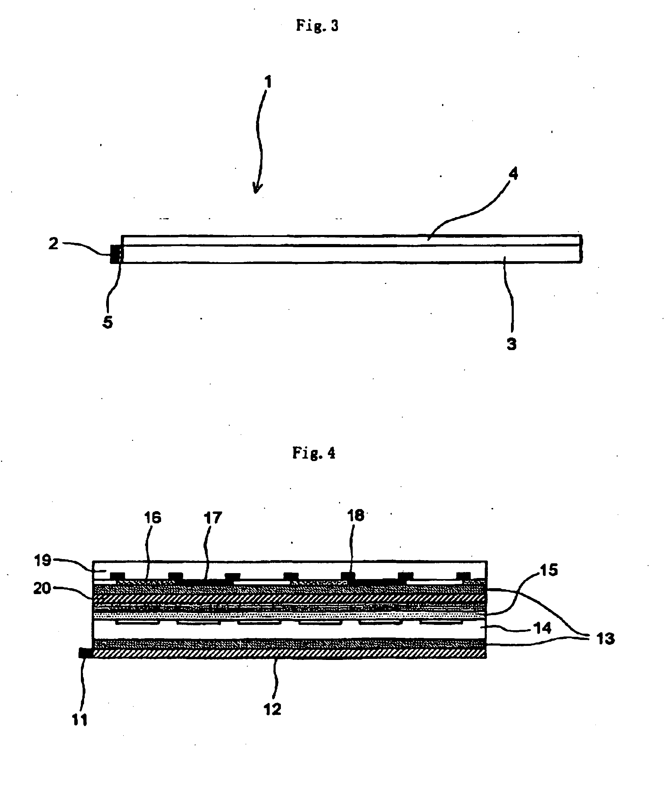

Hereinafter, a description will be given with reference to Fig. 3 (backlight unit (1)).

Light from a light-emitting diode (LED (2)) was converted in color by an iridium complex layer (5) to be white color and introduced into a light guide plate (3). On the light guide plate, a light-diffusing layer (4) (trade name: Panlite, manufactured by Teijin Chemicals Ltd.) having a thickness of 100 µm was formed, and thereby a backlight unit was formed. The brightness at a surface of the unit was 9000 cd/m². Furthermore, the color rendering index was 92. A schematic sectional view (sectional view of Example 19) of the obtained backlight unit is shown in Fig. 3.

### Example 20:

Hereinafter, a description will be given with reference to Fig. 4.

### Preparation of Color light-emitting Body Substrate;

On a glass substrate (19) having a diagonal length of 2.2 inches and a thickness of 0.7 mm, as a material of black matrix, V259BK (trade name, manufactured by NIPPON STEEL CHEMICAL Co., Ltd.) was applied by spin-coating, UV-exposed through a photomask so as to be a lattice-like pattern corresponding to QVGA, developed with a 2 % sodium carbonate aqueous solution, followed by baking at 200 °C, and thereby a pattern of black matrix (18) (film thickness: 1.5 µm) was formed.

As a material of a green-converting film, 0.5 g of an iridium (Ir) complex (E2) was dissolved in 100 g of acrylic negative photoresist (trade name: V259PA, solid content: 50%, manufactured by NIPPON STEEL CHEMICAL Co., Ltd.) to prepare ink. The ink was applied on the glass substrate by spin-coating, exposed to UV ray while positioning in accordance with the black matrix (18), developed with a 2% sodium carbonate aqueous solution, followed by baking at 150 °C, and thereby a green-converting fluorescent film (film thickness: 10 µm) containing a green light-emitting Ir complex (17) was formed.

In the next place, as a material of a red-converting film, 50 mg of an Ir complex (E17) was dissolved in 100 g of acrylic negative photoresist (trade name: V259PA, solid content: 50%, manufactured by NIPPON STEEL CHEMICAL Co., Ltd.) to prepare ink. In a manner similarly to the above, a red-converting film containing a red light-emitting Ir complex (16) (film thickness: 10 µm) was formed, and thereby a color light-emitting body substrate was obtained.

### Preparation of Opposite Electrode;

On one surface of a glass substrate (20) having the same cross-section surface shape as that of the color light-emitting body substrate and a thickness of 200 µm, a transparent electrode was formed, and on the other surface thereof a polarization film (polarization plate (13)) was attached. The surface to which the polarization film was attached and the surface of color light-emitting body substrate where a light-emitting body was formed were adhered and integrated, and thereby an opposite electrode substrate was obtained.

### Preparation of Liquid Crystal Panel;

By combining an amorphous silicon TFT panel (TFT substrate (14)) having a diagonal length of 2.2 inches and pixel electrodes corresponding to QVGA with the above opposite electrode, a liquid crystal panel was prepared by a conventional method. By combining the liquid crystal panel with the backlight unit made of a surface-mounting blue light-emitting diode (XT12 manufactured by Cree Inc.) (blue LED (11)) similar to that used in Example 2 and a light guide plate (12), a photo-luminescent liquid crystal display device was prepared. A schematic sectional view (sectional view of Example 20) of thus prepared photo-luminescent liquid crystal display device is shown in Fig. 4.

The color rendering index of the obtained display device was 92. Furthermore, since a light-emitting surface was nearer to the viewer than the liquid crystal (15) layer, there was no viewing angle dependence in the image quality. Still furthermore, since the LED light source was blue, after driven for 10, 000 hours, neither change in color nor reduction in light transmittance due to UV-deterioration was observed in the light guide plate and liquid crystal materials.

### Example 21:

Abacklight unit was prepared in the same manner as in Example 19 except that the same mixture of iridium complexes as that of Example 1 was applied to a thickness of 10 µm not on the edge face of the light guide plate but on the top surface of the diffusing layer. Light which entered in the light-diffusing layer was color-converted to white color by the iridium complex layer on the diffusing layer and exited as diffused light. The brightness at the unit surface was 9000 cd/m². Furthermore, the color rendering index was 92.

By use of the backlight, a QVGA liquid crystal display device having a diagonal length of 2.2 inches was prepared. The brightness when the obtained display device displayed white, green, blue and red on the entire surface thereof is shown in Table 2.

As a comparative example, by using the same polyacrylate resin as the above, a light guide plate same in the shape was formed, and by use of a device having an emission peak wavelength at 460 nm and an emission output power of 4.6 mW, a yellow fluorescent substances having an emission peak wavelength at 570 nm was mixed in a sealant epoxy resin, and thereby a surface-mounting type white LED was prepared. With four of the white LEDs disposed on the edge surface of the transparent light guide plate, a QVGA liquid crystal display device having the same diagonal length of 2.2 inches as the above was prepared.

**Table 2 : brightness of liquid crystal display device (unit:cd/m²)**

| | Example 13 | comparative example |
|---|---|---|
| white on the entire surface | 380 | 200 |
| green on the entire surface | 750 | 320 |
| blue on the entire surface | 29 | 45 |
| red on the entire surface | 180 | 50 |

Since the entire surface of the diffusing layer emitted uniformly, the light could be utilized more efficiently and the brightness was improved as compared with the comparative example. Furthermore, if the white LED of the device for comparative example is used as a backlight, green and red colors can hardly be reproduced.

### Example 22:

In a mixture of 5 g of bisphenol A diglycidyl ether and 5 g of methylhexahydrophthalic anhydride, 9 mg of an Ir complex (E2) and 1 mg of an Ir complex (E17) were added and mixed, followed by defoaming.

This was dissolved in 20 g of toluene, followed by coating a surface of a polarization film on a light incident surface of a liquid crystal display device with the mixture by use of a doctor blade. A dry thickness thereof was 10 µm.

A colorless and transparent polymethyl methacrylate (manufactured by Kuraray Co., Ltd.) was used as a light guide plate and four surface-mountingtypelight-emitting diodes having a peak emission wavelength at 460 nm and an emission output of 4.6 mW were disposed on the edge surface of the light guide plate to emit. The brightness when the entire surface emitted in white, green, blue and red color was measured, and results thereof are shown in Table 3.

**Table 3:brightness of liquid crystal display device (unit:cd/m²)**

| | |
|---|---|
| white on the entire surface | 380 |
| green on the entire surface | 750 |
| blue on the entire surface | 29 |
| red on the entire surface | 180 |

### Example 23:

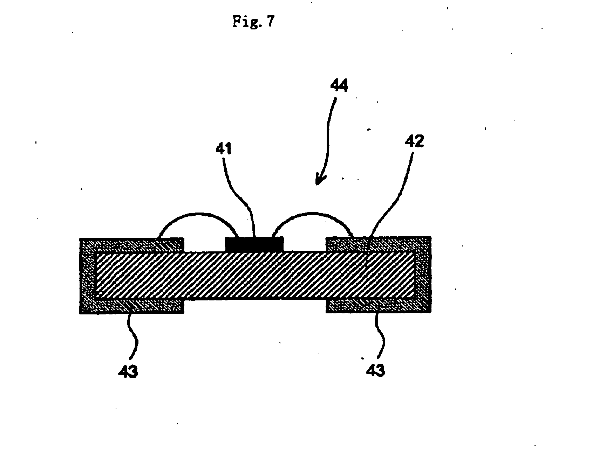

As in Fig.7 showing the structure, placed on mounting substrate 42 was InGaN light-emitting diode chip 41 having an emission wavelength of 470 nm and an emission output of 4.6 mW and this was electrically connected with metal electrode 43, to thereby fabricate a light-emitting diode element 44.

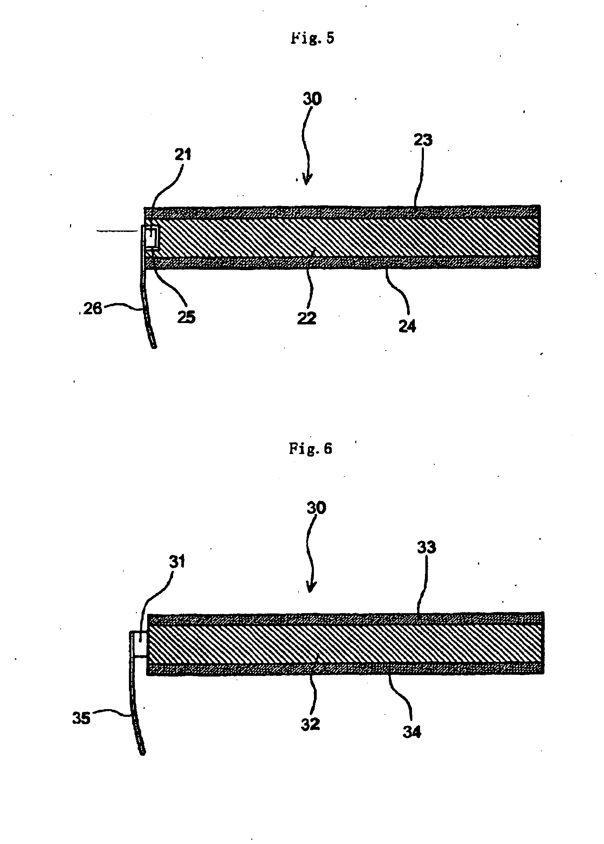

Further, as in Fig.5 showing the structure, a transparent acrylic resin plate (refractive index 1.5) of 4 cm × 5 cm × 0.8 cm was used as a light guide plate 22 for backlight unit and the edge surface of the short side was subjected to groove process to thereby form four square dents 25 at regular intervals (with a proviso that both end portions are half of the interval between dents).

Next, 500 mg of YAG (cerium doped yttrium aluminum garnet) fluorescent material was dispersed in 5 g of epoxy resin (refractive index 1.6, EL438 manufactured by SANYU REC CO. LTD.), and the resultant was poured into the four dents while leaving the space for the volume of the light-emitting diode elements unfilled.

Then, placed into the dents were the four light-emitting diode elements 21 which had been in advance adhered onto the electrodes on a flexible board 26 by using a electroconductive resin adhesive in such a manner that the electrodes of the LED could contact the electrodes of the flexible board.

Subsequently, this was subjected to heat treatment at 120 °C for 4 hours to thereby cure the resin to form a fluorescent layer. At the same time, the fluorescent layer was bonded to the light guide plate to thereby obtain an integrated light source unit.

Then, an alumite plate 24 was adhered to the bottom surface of the light source unit by using an epoxy adhesive (refractive index 1.6). Further, a light diffuser plate 23 (Panlite sheet, manufactured by TEIJIN CHEMICALS, LTD.) was adhered to the emission surface of the light guide plate by using an acrylic adhesive (refractive index 1.5), to thereby prepare an integrated planar light-emitting device as shown in Fig. 5.

Electric current of 3.27 V and 20 mA was applied to the four LEDs of the obtained planar light-emitting device to allow light emission. At that time, the surfacebrightness in the center of the planar light-emitting device was 520 cd/m². Further, the light-expression area was equally divided lengthwise and crosswise respectively thrice into three parts respectively to thereby obtain nine lots. The brightness in the center of each of the nine lots was measured and the value of unevenness in brightness (the value obtained by dividing the difference between the highest brightness value and the lowest brightness value by the average value of the nine points) was 23 %.

### Example 24:

Resin prepared in the same manner as in Example 23 except that 8.5 mg of iridium complex compound of formula (E2) and 1.5 mg of iridium complex compound of formula (E17) were used instead of YAG and were dispersed in 10 g of epoxy resin, was poured into the dents at an equal amount (5 mg), and then cured at 120 °C for 4 hours. The subsequent procedures were conducted in the same manner as in Example 23 to thereby obtain a planar light-emitting device. Also, brightness was evaluated in the same condition as in Example 23. As a result, the surface brightness in the center of the planar light-emitting device was 510 cd/m². The value of unevenness in brightness was 26 %.

### Example 25:

A planar light-emitting device was prepared in the same manner as in Example 23 except that the cross-section of the light entrance face of the dents in the light guide plate had a shape of a convex-lens. Brightness was evaluated in the same condition. As a result, the surface brightness in the center of the planar light-emitting device was 480 cd/m². The value of unevenness in brightness was 20 %.

### Reference Example 1:

The same type of light-emitting diode chip as in Example 23 was placed in a surface-mounting package of side-view type and sealed by using a mixture of YAG fluorescent material and an epoxy resin similarly to Example 23, to thereby obtain light-emitting diode elements 31. The four elements were pressure-bonded to the edge surface of the light guide plate 32 having the same size as that of the light guide plate used in Example 23 and having no dents, to thereby obtain a light source unit 30. Similarly to Example 23, the light source unit was placed on an alumite reflector 34, and further a light diffuser plate 33 (Panlite sheet, manufactured by TEIJIN CHEMICALS, LTD.) was placed on the opposite side of the light guide plate 32, to thereby set up a planar light-emitting device as shown in Fig. 6. Brightness was evaluated in the same condition as in Example 23. As a result, the surface brightness in the center of the planar light-emitting device was 410 cd/m². The value of unevenness in brightness was 58 %.

## Claims

1. Alight-emitting body comprising a primary luminescent unit and a secondary luminescent unit that emits light owing to light emitted from the primary luminescent unit, wherein the secondary luminescent unit contains an iridium complex represented by formula (1)
L¹L²L³Ir (1)
wherein L¹, L² and L³ are organic bidentate ligands coordinated to iridium, and at least one of these ligands coordinates with a nitrogen atom and a carbon atom,
and the primary luminescent unit emits light of a wavelength in the range of 350 to 530 nm.

2. The light-emitting body according to claim 1, wherein the iridium complex is represented by formula (2) 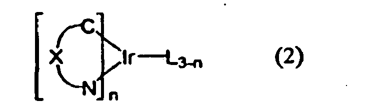 wherein X represents an atom group that forms an aromatic chelate ligand together with a carbon atom and a nitrogen atom bonded with iridium, n is an integer of 2 or 3, the multiple X's present in each aromatic chelate group may be the same or different from each other, and L represents a bidentate organic ligand wherein the atoms other than carbon atoms are bonded with iridium.

3. The light-emitting body according to claim 2, wherein the inside of [ ] in formula (2) is any one of ligands selected from a group of structural formulas shown by formula (3) 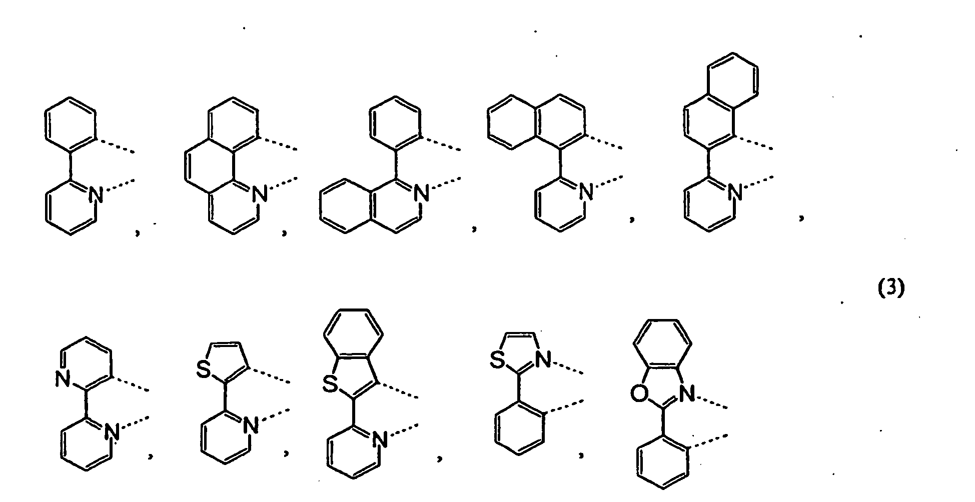 wherein a dotted line shows bonding with iridium, each hydrogen atom on the aromatic rings may be substituted by a halogen atom or an organic group having 1 to 15 carbon atoms, and when n represents a plural number, the ligands may be different from each other.

4. The light-emitting body according to claim 2, wherein the iridium complex is represented by formula (4) 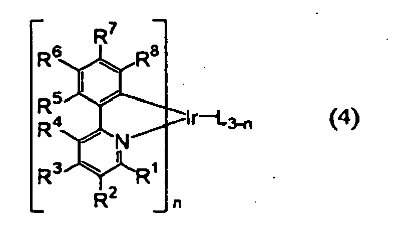 wherein R¹ through R⁸ independently represent a hydrogen atom, a halogen atom or an organic group having 1 to 15 carbon atoms, substituent groups (R¹ through R⁸) adjacent to each other may be bonded at one or more sites to thereby form a condensed ring, n is an integer of 2 or 3, two or three ligands shown by the inside of [ ] may be same or different from each other, and L represents a bidentate organic ligand wherein the atoms other than carbon atom are bonded to iridium.

5. The light-emitting body according to claim 2, wherein the iridium complex is represented by formula (5) or (6) 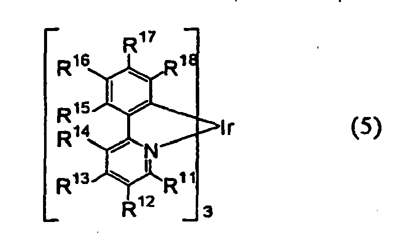 wherein R¹¹ through R¹⁸ independently represent a hydrogen atom or an alkyl group having 1 to 10 carbon atoms, 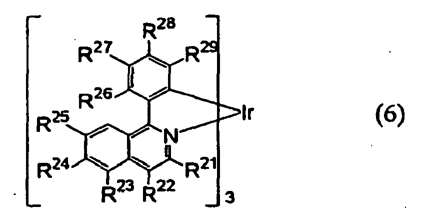 wherein R²¹ through R²⁹ independently represent a hydrogen atom or an alkyl group having 1 to 10 carbon atoms.

6. The light-emitting body according to any one of claims 2 to 4, wherein the bidentate organic ligand L is any one ligand selected from a group of structural formulas shown by formula (7) 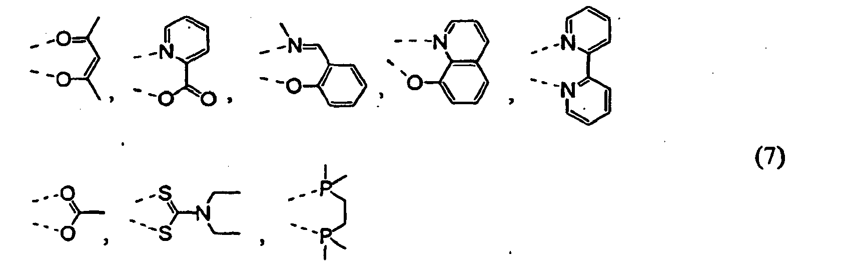 wherein a dotted line shows bonding with iridium, and a carbon atom in each of the ligands may be substituted by an organic group having 1 to 15 carbon atoms.

7. The light-emitting body according to claim 1, wherein the secondary luminescent unit is one obtained by forming an iridium complex in layer form on a transparent substrate or on the emission surface of the primary luminescent unit.

8. The light-emitting body according to claim 7, wherein the secondary luminescent unit on a transparent substrate or on the emission surface of the primary luminescent unit consists of multiple layers.

9. The light-emitting body according to claim 8, wherein the secondary luminescent unit consists of a composition layer containing an iridium complex provided on a transparent substrate or on the emission surface of the primary luminescent unit and another composition layer containing no iridium complex further laminated thereon.

10. The light-emitting body according to claim 8, wherein the secondary luminescent unit consists of a composition layer containing no iridium complex provided on a transparent substrate or on the emission surface of the primary luminescent unit, another composition layer containing an iridium complex which layer is further laminated thereon and still another composition layer containing no iridium complex which layer is still further laminated thereon.

11. The light-emitting body according to claim 10, wherein the composition layer containing no iridium complex which layer is laminated on the composition layer containing an iridium complex is a CVD carbon-coated layer.

12. The light-emitting body according to claim 7, wherein the iridium complex is an iridium complex having a bidentate organic ligand L represented by formula (7) described in claim 6.

13. The light-emitting body according to claim 7, wherein the iridium complex is one or more compounds selected from a group of iridium complexes shown by formulas (E1) through (E32) below

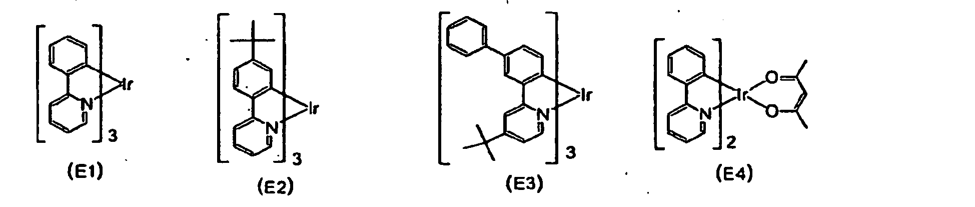

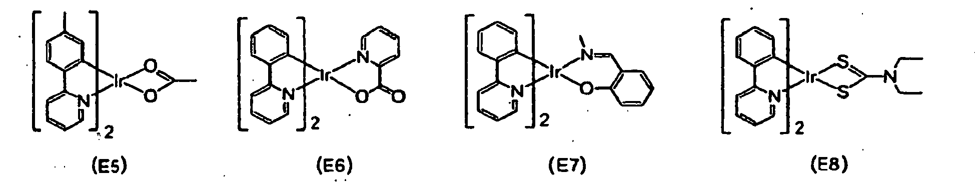

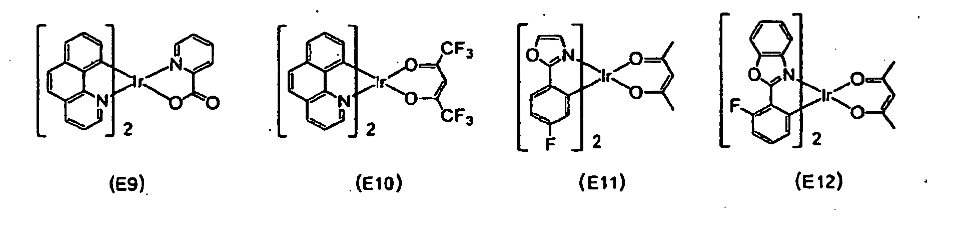

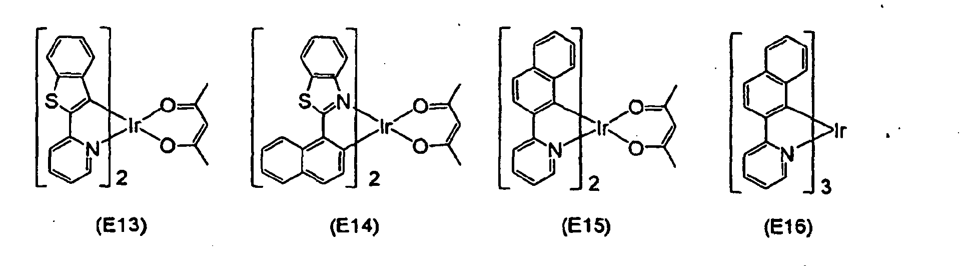

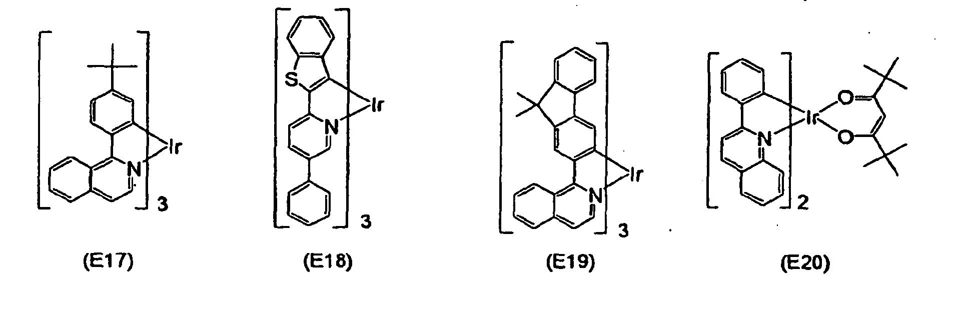

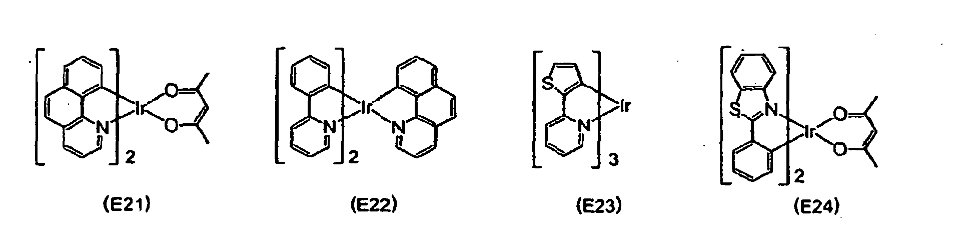

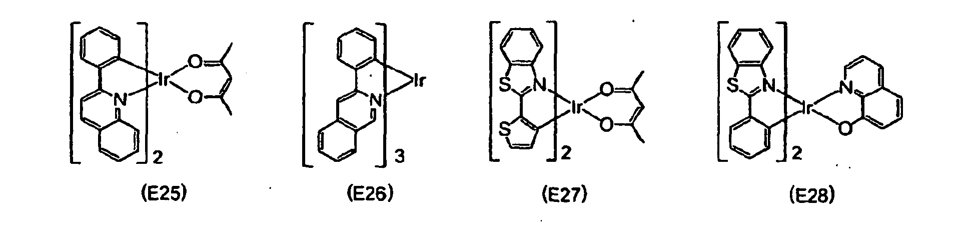

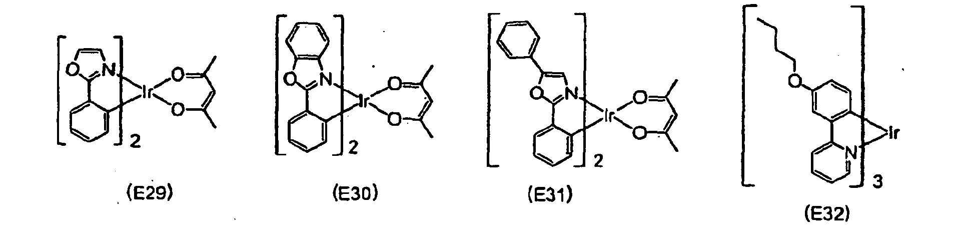

14. The light-emitting body according to claim 1, wherein the secondary luminescent unit is prepared by dissolving or dispersing an iridium complex in a binder and the secondary luminescent unit is placed in such a manner that the emission surface of the primary luminescent unit is covered.

15. The light-emitting body according to claim 1, wherein the primary luminescent unit is a blue light-emitting diode.

16. The light-emitting body according to claim 15, wherein the primary luminescent unit is a gallium nitride compound semiconductor.

17. The light-emitting body according to claim 1, comprising a structure wherein on a light path of light generated by the primary luminescent unit, the secondary luminescent unit containing a binder having an iridium complex dissolved or dispersed therein is disposed to emit white light.

18. The light-emitting body according to claim 17, wherein the secondary luminescent unit disposed on a light path of light generated by the primary luminescent unit contains a binder having at least two kinds of iridium complexes including an iridium complex having an emission peak in 510 to 570 nm and an iridium complex having an emission peak in 600 to 680 nm dissolved or dispersed therein.

19. The light-emitting body according to any one of claims to 1 to 18, wherein the color rendering index is 80 or more.

20. The light-emitting body according to claim 18, wherein the primary luminescent unit is a light-emitting diode emitting light having a wavelength in 350 to 530 nm and white light with a color rendering index of 90 or more is extracted.

21. The light-emitting body according to claim 17 or 18, wherein the binder is used as a light guide plate or a diffuser plate.

22. A method of producing the light-emitting body according to claim 7, wherein the secondary luminescent unit containing an iridium complex is formed on a transparent substrate which receives light from the primary luminescent unit by any one method of coating, spin-coating and printing.

23. A method of producing the light-emitting body according to claim 7, wherein the secondary luminescent unit containing an iridium complex is formed on the emission surface of the primary luminescent unit by any one method of curing after dripping, printing and sealing, dispenser method, transfer-molding, injection-molding and spin-coating.

24. A lighting device including the light-emitting body according to any one of claims 1 to 21.

25. A display device including the light-emitting body according to any one of claims 1 to 21.

26. The display device according to claim 25, using the light-emitting body as a backlight.

27. The display device according to claim 25 or 26, wherein a light-emitting body is formed on one surface of the transparent substrate to be a secondary luminescent unit, further on the light-emitting body or on a surface opposite to the surface on which the light-emitting body is formed, a transparent electrode is formed, and the transparent electrode is used as one electrode of a transmissive liquid crystal display device.

28. A planar light-emitting device comprising multiple primary luminescent units, a secondary luminescent unit which is excited by light emitted by the primary luminescent units to emit light, a light guideplate, a reflectorplate and a diffuser plate, wherein the secondary luminescent unit contains an iridium compound as defined in claim 1.

29. The planar light-emitting device according to claim 28, wherein all the contact surfaces of the constituents constituting the planar light-emitting device are closely adhered to and integrated with each other in such a manner that substantially no air can be present in the interfaces.

30. The planar light-emitting device according to claim 29, wherein the constituents are bonded with adhesive agent or by thermocompression.

31. The planar light-emitting device according to claim 30, wherein the adhesive agent is an epoxy resin having a refractive index of 1.4 or more or an acrylic resin having a refractive index of 1.4 or more.

32. The planar light-emitting device according to claim 31, wherein the secondary luminescent unit is formed by dissolving or dispersing the iridium compound in the adhesive agent for bonding the multiple primary luminescent units with the light guide plate.

33. The planar light-emitting device according to claim 28, wherein the primary luminescent units are placed inmultiple dents formed in the edge portion of the light guide plate.

34. The planar light-emitting device according to claim 33, wherein the cross-section of a light entrance face of the dent of the light guide plate has a gibbous form and the adhesive agent used for sealing the dent portions has a higher refractive index than the refractive index of the light guide plate.

35. The planar light-emitting device according to claim 28, wherein the reflector plate is an aluminum plate, a white-coated aluminum plate, an evaporated silver film or a white film.

36. The planar light-emitting device according to claim 28, wherein the primary luminescent units are light-emitting diodes.

37. A liquid crystal display backlight system using the planar light-emitting device according to any one of claims 28 to 36.

## Patentansprüche

1. Lichtemittierender Körper, der eine primäre lumineszierende Einheit und eine sekundäre lumineszierende Einheit aufweist, welche Licht emittiert, das auf Licht beruht, das von der primären lumineszierenden Einheit emittiert wird, wobei die sekundäre lumineszierende Einheit einen Iridiumkomplex der Formel (1) aufweist,
L¹L²L³Ir (1)
worin L¹, L² und L³ organische zweizähnige Liganden sind, die an Iridium koordiniert sind, und mindestens einer dieser Liganden mit einem Stickstoffatom und einem Kohlenstoffatom koordiniert ist,
und die primäre lumineszierende Einheit Licht einer Wellenlänge im Bereich von 350 bis 530 nm emittiert.

2. Lichtemittierender Körper nach Anspruch 1, worin der Iridiumkomplex durch die Formel (2) dargestellt ist 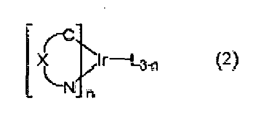 worin X eine Atomgruppe darstellt, die zusammen mit einem Kohlenstoffatom und einem Stickstoffatom, die an Iridium gebunden sind, einen aromatischen Chelatliganden bildet, n die ganze Zahl 2 oder 3 ist, die in jeder aromatischen Chelatgruppe vorhandenen Substituenten X gleich oder verschieden voneinander sein können und L einen zweizähnigen organischen Liganden darstellt, wobei die anderen Atome als die Kohlenstoffatome mit Iridium verbunden sind.

3. Lichtemittierender Körper nach Anspruch 2, worin das Innere der [] in Formel (2) ein beliebiger der Liganden ist, die unter einer Gruppe der Strukturformeln der Formel (3) 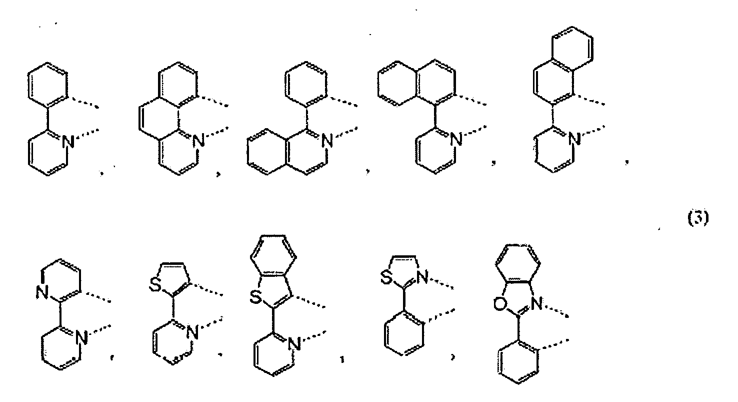 ausgewählt sind,
worin eine gepunktete Linie eine Bindung mit Iridium angibt, jedes Wasserstoffatom auf den aromatischen Ringen durch ein Halogenatom oder eine organische Gruppe mit 1 bis 15 Kohlenstoffatomen substituiert sein kann und, wenn n eine Mehrzahl darstellt, die Liganden voneinander verschieden sein können.

4. Lichtemittierender Körper nach Anspruch 2, worin der Iridiumkomplex durch die Formel (4) dargestellt ist 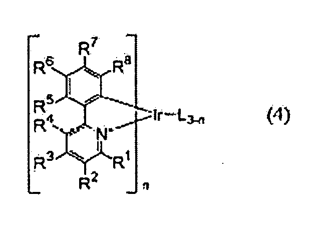 worin R¹ bis R⁸ unabhängig voneinander ein Wasserstoffatom, ein Halogenatom oder eine organische Gruppe mit 1 bis 15 Kohlenstoffatomen darstellt, die Substituentengruppen (R¹ bis R⁸), die einander benachbart sind, an einer oder mehreren Stellen verbunden sein können, wodurch ein kondensierter Ring gebildet wird, n die ganze Zahl 2 oder 3 ist, zwei oder drei Liganden, die im Inneren der [] angegeben sind, gleich oder verschieden voneinander sein können und L einen zweizähnigen organischen Liganden darstellt, wobei die anderen Atome als die Kohlenstoffatome an Iridium gebunden sind.

5. Lichtemittierender Körper nach Anspruch 2, worin der Iridiumkomplex durch die Formel (5) oder (6) dargestellt ist 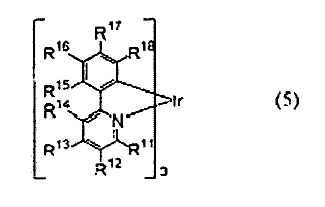 worin R¹¹ bis R¹⁸ unabhängig voneinander ein Wasserstoffatom oder eine Alkylgruppe mit 1 bis 10 Kohlenstoffatomen darstellen, 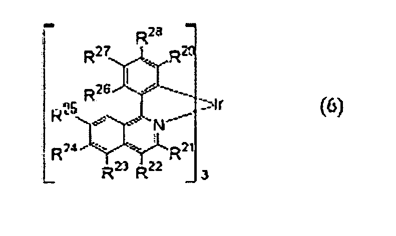 worin R²¹ bis R²⁹ unabhängig voneinander ein Wasserstoffatom oder eine Alkylgruppe mit 1 bis 10 Kohlenstoffatomen darstellen.

6. Lichtemittierender Körper nach einem der Ansprüche 2 bis 4, wobei der zweizähnige organische Ligand L ein beliebiger Ligand ist, der aus der Gruppe der Strukturformeln der Formel (7) ausgewählt ist 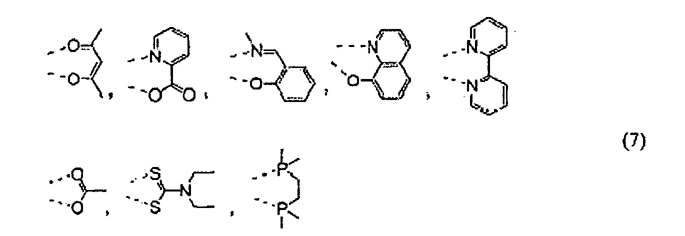 wobei eine gepunktete Linie eine Bindung mit Iridium zeigt und ein Kohlenstoffatom in jedem der Liganden durch eine organische Gruppe mit 1 bis 15 Kohlenstoffatomen substituiert sein kann.

7. Lichtemittierender Körper nach Anspruch 1, worin die sekundäre lumineszierende Einheit durch Bilden eines Iridiumkomplexes in Schichtform auf einem transparenten Substrat oder auf der Emissionsoberfläche der primären lumineszierenden Einheit erhalten worden ist.

8. Lichtemittierender Körper nach Anspruch 7, worin die zweite lumineszierende Einheit auf einem transparenten Substrat oder auf der Emissionsoberfläche der primären lumineszierenden Einheit aus mehreren Schichten besteht.

9. Lichtemittierender Körper nach Anspruch 8, worin die zweite lumineszierende Einheit aus einer einen Iridiumkomplex enthaltenden Verbundschicht, die auf einem transparenten Substrat oder auf der Emissionsoberfläche der primären lumineszierenden Einheit angebracht ist, und aus einer weiteren Verbundschicht besteht, die keinen weiteren darauf laminierten Iridiumkomplex enthält.

10. Lichtemittierender Körper nach Anspruch 8, worin die zweite lumineszierende Einheit aus einer keinen Iridiumkomplex enthaltenden Verbundschicht, die auf einem transparenten Substrat oder auf der Emissionsoberfläche der primären lumineszierenden Einheit angebracht ist, aus einer weiteren darauf laminierten Verbundschicht, die einen Iridiumkomplex enthält, und aus noch einer weiteren darauf laminierten Verbundschicht besteht, die keinen Iridiumkomplex enthält.

11. Lichtemittierender Körper nach Anspruch 10, worin die keinen Iridiumkomplex enthaltende Verbundschicht, die auf die einen Iridiumkomplex enthaltende Verbundschicht laminiert ist, eine kohlenstoffbeschichtete CVD-Schicht ist.

12. Lichtemittierender Körper nach Anspruch 7, worin der Iridiumkomplex ein Iridiumkomplex mit einem zweizähnigen organischen Liganden L der in Anspruch 6 beschriebenen Formel (7) ist.

13. Lichtemittierender Körper nach Anspruch 7, worin der Iridiumkomplex eine oder mehrere Verbindungen ist, die aus der Gruppe aus Iridiumkomplexen ausgewählt ist, die in den nachstehenden Formeln (E1) bis (E32) gezeigt sind:

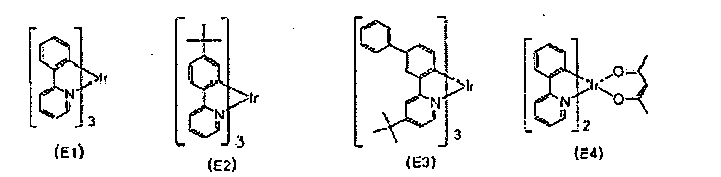

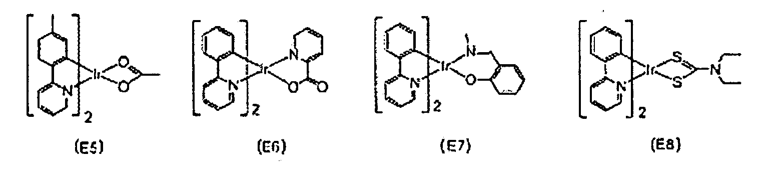

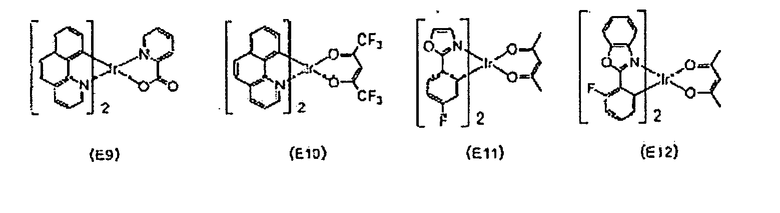

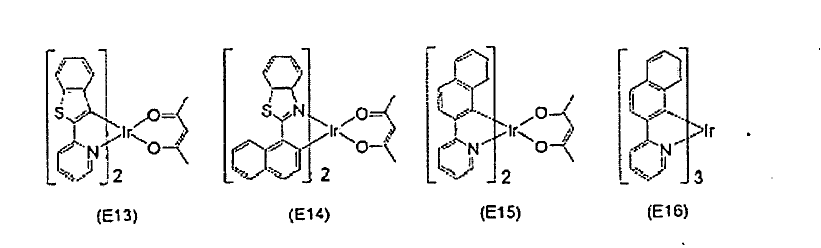

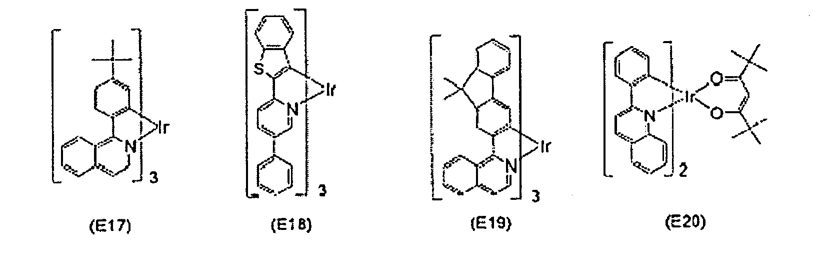

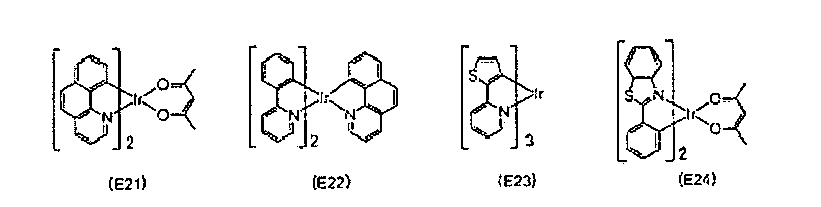

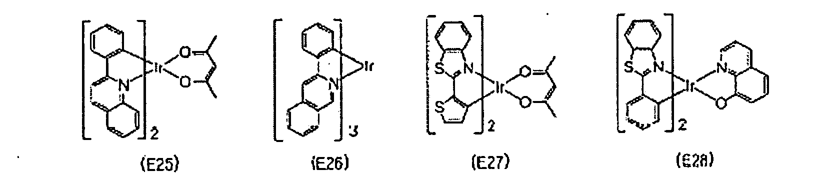

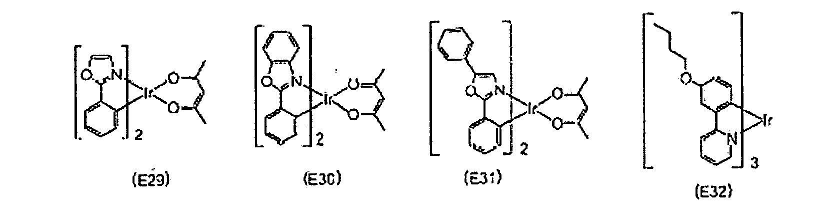

14. Lichtemittierender Körper nach Anspruch 1, worin die sekundäre lumineszierende Einheit hergestellt wird, indem ein Iridiumkomplex in einem Bindemittel aufgelöst oder dispergiert wird und die sekundäre lumineszierende Einheit auf eine solche Weise angebracht wird, dass die Emissionsoberfläche der primären lumineszierenden Einheit bedeckt ist.

15. Lichtemittierender Körper nach Anspruch 1, worin die primäre lumineszierende Einheit eine Diode ist, die blaues Licht emittiert.

16. Lichtemittierender Körper nach Anspruch 15, worin die primäre lumineszierende Einheit ein Galliumnitridverbindungshalbleiter ist.

17. Lichtemittierender Körper nach Anspruch 1, der eine Struktur aufweist, bei der auf einem Lichtweg des Lichts, das durch die primäre lumineszierende Einheit erzeugt wird, die sekundäre lumineszierende Einheit, die ein Bindemittel mit einem darin aufgelösten oder dispergierten Iridiumkomplex enthält, angebracht ist, um weißes Licht zu emittieren.

18. Lichtemittierender Körper nach Anspruch 17, worin die sekundäre lumineszierende Einheit, die auf einem Lichtweg des Lichts angebracht ist, das durch die primäre lumineszierende Einheit erzeugt wird, ein Bindemittel enthält, worin mindestens zwei Arten von Iridiumkomplexen, einschließlich einem Iridiumkomplex mit einem Emissionspeak bei 510 bis 570 nm und einem Iridiumkomplex mit einem Emissionspeak von 600 bis 680 nm, aufgelöst oder dispergiert sind.

19. Lichtemittierender Körper nach einem der Ansprüche 1 bis 18, worin der Farbwiedergabeindex 80 oder mehr ist.

20. Lichtemittierender Körper nach Anspruch 18, worin die primäre lumineszierende Einheit eine lichtemittierende Diode ist, die Licht einer Wellenlänge von 350 bis 530 nm emittiert, und weißes Licht mit einem Farbwiedergabeindex von 90 oder mehr extrahiert wird.

21. Lichtemittierender Körper nach Anspruch 17 oder 18, worin das Bindemittel als Lichtführungsschicht oder Diffusorschicht eingesetzt wird.

22. Verfahren zum Herstellen eines lichtemittierenden Körpers nach Anspruch 7, wobei die einen Iridiumkomplex enthaltende zweite lumineszierende Einheit durch ein beliebiges, unter Beschichten, Wirbelbeschichten oder Drucken ausgewähltes Verfahren auf einem Licht von der primären lumineszierenden Einheit erhaltenden transparenten Substrat gebildet wird.

23. Verfahren zum Herstellen eines lichtemittierenden Körpers nach Anspruch 7, wobei die einen Iridiumkomplex enthaltende zweite lumineszierende Einheit durch ein beliebiges, unter Härten nach Eintauchen, Drucken und Versiegeln, Abfüllverfahren, Transfergießen, Spritzgießen und Wirbelbeschichten ausgewähltes Verfahren auf der Emissionsoberfläche der primären lumineszierenden Einheit gebildet wird.

24. Leuchtvorrichtung, welche den lichtemittierenden Körper nach einem der Ansprüche 1 bis 21 enthält.

25. Anzeigevorrichtung, welche den lichtemittierenden Körper nach einem der Ansprüche 1 bis 21 enthält.

26. Anzeigevorrichtung nach Anspruch 25, welche den lichtemittierenden Körper als Gegenlicht verwendet.

27. Anzeigevorrichtung nach Anspruch 25 oder 26, worin ein lichtemittierender Körper auf einer Oberfläche des transparenten Substrats unter Bildung einer sekundären lumineszierenden Einheit gebildet ist, außerdem auf dem lichtemittierenden Körper oder auf der Oberfläche, die der Oberfläche, auf der der lichtemittierende Körper gebildet ist, gegenüberliegt, eine transparente Elektrode gebildet ist, und die transparente Elektrode als eine Elektrode einer Transmissions flüssigkristallan zeigevorrichtung eingesetzt wird.

28. Planare lichtemittierende Vorrichtung, welche mehrere primäre lumineszierende Einheiten, eine sekundäre lumineszierende Einheit, die unter Emittieren von Licht durch das Licht angeregt wird, das von den primären lumineszierenden Einheiten emittiert wird, eine Lichtführungsschicht, eine Reflektorschicht und eine Diffusorschicht umfasst, wobei die sekundäre lumineszierende Einheit eine in Anspruch 1 definierte Iridiumverbindung enthält.

29. Planare lichtemittierende Vorrichtung nach Anspruch 28, worin alle Kontaktoberflächen der Bestandteile der planaren lichtemittierenden Vorrichtung eng aneinander haften und miteinander auf eine solche Weise integriert sind, dass in den Zwischenräumen im wesentlichen keine Luft vorhanden sein kann.

30. Planare lichtemittierende Vorrichtung nach Anspruch 29, worin die Bestandteile mit Klebemitteln oder durch Thermokompression aneinander gebunden sind.

31. Planare lichtemittierende Vorrichtung nach Anspruch 30, worin das Klebemittel ein Epoxyharz mit einem Brechungsindex von 1,4 oder höher oder ein Acrylharz mit einem Brechungsindex von 1,4 oder höher ist.

32. Planare lichtemittierende Vorrichtung nach Anspruch 31, worin die sekundäre lumineszierende Einheit durch Auflösen oder Dispergieren der Iridiumverbindung in dem Klebemittel zum Binden der mehreren primären lumineszierenden Einheiten an die Lichtführungsschicht gebildet ist.

33. Planare lichtemittierende Vorrichtung nach Anspruch 28, worin die primären lumineszierenden Einheiten in mehreren Einbuchtungen angebracht sind, die in den Randbereichen der Lichtführungsschicht gebildet sind.

34. Planare lichtemittierende Vorrichtung nach Anspruch 33, worin der Querschnitt einer Lichteingangsfläche der Einbuchtung der Lichtführungsschicht eine auf beiden Seiten konvexe Form aufweist und das Klebemittel, das zum Versiegeln der Einbuchtungsbereiche verwendet wird, einen höheren Brechungsindex hat als die Lichtführungsschicht.

35. Planare lichtemittierende Vorrichtung nach Anspruch 28, worin die Reflektorschicht eine Aluminiumschicht, weiß beschichtete Aluminiumschicht, ein Silberdampffilm oder ein weißer Film ist.

36. Planare lichtemittierende Vorrichtung nach Anspruch 28, worin die primären lumineszierenden Einheiten lichtemittierende Dioden sind.

37. Flüssigkristallan zeigegegenlicht system unter Verwendung der planaren lichtemittierenden Vorrichtung nach einem der Ansprüche 28 bis 36.

## Revendications

1. Corps électroluminescent comprenant une unité luminescente primaire et une unité luminescente secondaire qui émet de la lumière en raison de la lumière émise depuis l'unité luminescente primaire, dans lequel l'unité luminescente secondaire contient un complexe d'iridium représenté par la formule (1)
L¹L²L³Ir (1)
dans laquelle L¹, L² et L³ sont des ligands bidentate organiques coordonnés à l'iridium, et au moins un de ces ligands se coordonne avec un atome d'azote et un atome de carbone, et l'unité luminescente primaire émet de la lumière d'une longueur d'onde dans la plage de 350 à 530 nm.

2. Corps électroluminescent selon la revendication 1, dans lequel le complexe d'iridium est représenté par la formule (2) 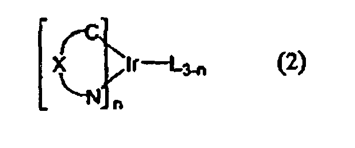 dans laquelle X représente un groupe d'atomes qui forme un ligand chélate aromatique avec un atome de carbone et un atome d'azote liés avec l'iridium, n est un entier de 2 ou 3, les multiples X présents dans chaque groupe chélate aromatique peuvent être identiques ou différents les uns des autres, et L représente un ligand organique bidentate dans lequel les atomes autres que les atomes de carbone sont liés avec l'iridium.

3. Corps électroluminescent selon la revendication 2, dans lequel l'intérieur des [] dans la formule (2) est l'un quelconque des ligands choisi dans un groupe de formules structurales montré par la formule (3) 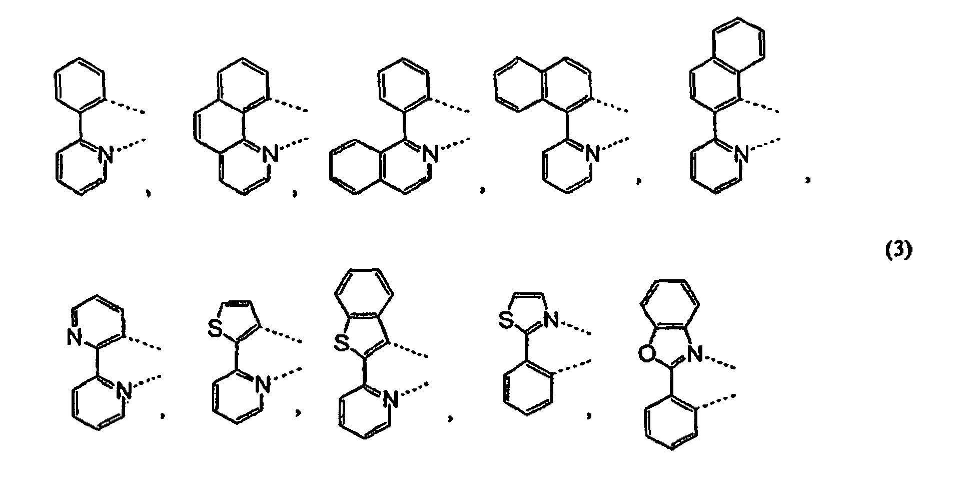 dans lequel une ligne pointillée montre la liaison avec l'iridium, chaque atome d'hydrogène sur les cycles aromatiques peut être substitué par un atome d'halogène ou un groupe organique comportant de 1 à 15 atomes de carbone, et lorsque n représente un nombre pluriel, les ligands peuvent être différents les uns des autres.

4. Corps électroluminescent selon la revendication 2, dans lequel le complexe d'iridium est représenté par la formule (4) 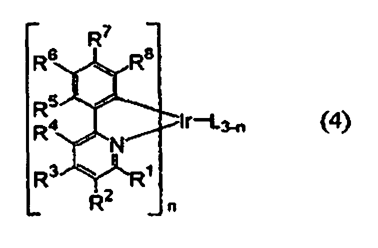 dans laquelle R¹ à R⁸ représentent indépendamment un atome d'hydrogène, un atome d'halogène ou un groupe organique comportant de 1 à 15 atomes de carbone, des groupes substituants (R¹ à R⁸) adjacents les uns aux autres peuvent être liés à un ou plusieurs sites pour former ainsi un cycle condensé, n est un entier de 2 ou 3, deux ou trois ligands montrés par l'intérieur des [] peuvent être identiques ou différents les uns des autres, et L représente un ligand organique bidentate dans lequel les atomes autres que l'atome de carbone sont liés à l'iridium.

5. Corps électroluminescent selon la revendication 2, dans lequel le complexe d'iridium est représenté par la formule (5) ou (6) 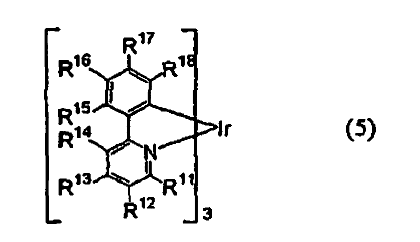 dans laquelle R¹¹ à R¹⁸ représentent indépendamment un atome d'hydrogène ou un groupe alkyle comportant de 1 à 10 atomes de carbone, 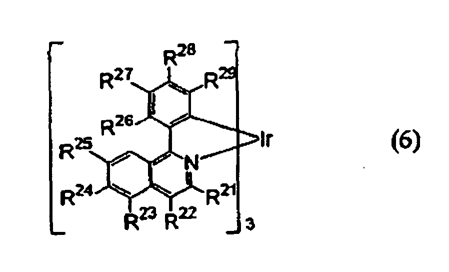 dans laquelle R²¹ à R²⁹ représentent indépendamment un atome d'hydrogène ou un groupe alkyle comportant de 1 à 10 atomes de carbone.

6. Corps électroluminescent selon l'une quelconque des revendications 2 à 4, dans lequel le ligand organique bidentate L est un ligand quelconque choisi dans un groupe de formules structurales montré par la formule (7) 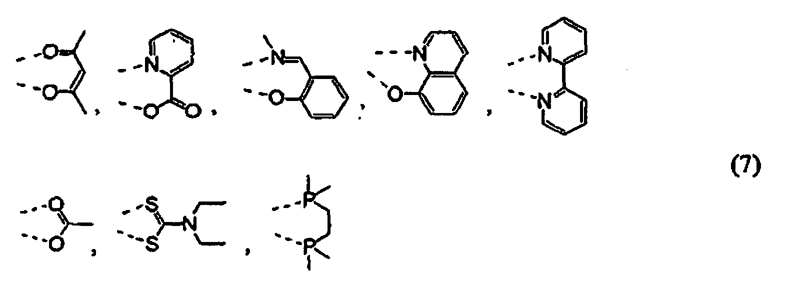 dans lequel une ligne pointillée montre la liaison avec l'iridium, et un atome de carbone dans chacun des ligands peut être substitué par un groupe organique comportant de 1 à 15 atomes de carbone.

7. Corps électroluminescent selon la revendication 1, dans lequel l'unité luminescente secondaire est une unité obtenue en formant un complexe d'iridium sous forme de couche sur un substrat transparent ou sur la surface d'émission de l'unité luminescente primaire.

8. Corps électroluminescent selon la revendication 7, dans lequel l'unité luminescente secondaire sur un substrat transparent ou sur la surface d'émission de l'unité luminescente primaire est constituée de multiples couches.

9. Corps électroluminescent selon la revendication 8, dans lequel l'unité luminescente secondaire est constituée d'une couche de composition contenant un complexe d'iridium formé sur un substrat transparent ou sur la surface d'émission de l'unité luminescente primaire et une autre couche de composition ne contenant pas de complexe d'iridium stratifié en outre sur celle-ci.

10. Corps électroluminescent selon la revendication 8, dans lequel l'unité luminescente secondaire est constituée d'une couche de composition ne contenant pas de complexe d'iridium formé sur un substrat transparent ou sur la surface d'émission de l'unité luminescente primaire, une autre couche de composition contenant un complexe d'iridium, laquelle couche est stratifiée en outre sur celle-ci et encore une autre couche de composition ne contenant pas de complexe d'iridium, laquelle couche est encore davantage stratifiée sur celle-ci.

11. Corps électroluminescent selon la revendication 10, dans lequel la couche de composition ne contenant pas de complexe d'iridium, laquelle couche est stratifiée sur la couche de composition contenant un complexe d'iridium est une couche revêtue de carbone par dépôt chimique en phase vapeur.

12. Corps électroluminescent selon la revendication 7, dans lequel le complexe d'iridium est un complexe d'iridium ayant un ligand organique bidentate L représenté par la formule (7) décrite dans la revendication 6.

13. Corps électroluminescent selon la revendication 7, dans lequel le complexe d'iridium est un ou plusieurs composés choisis dans un groupe de complexes d'iridium montré par les formules (E1) à (E2) ci-dessous

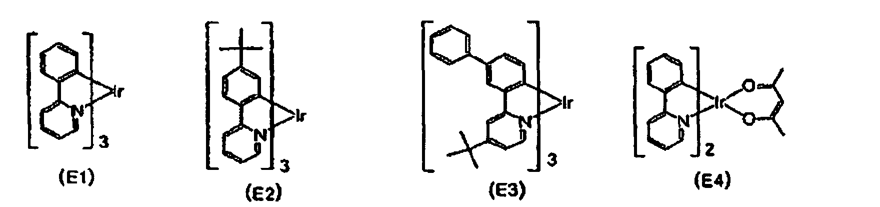

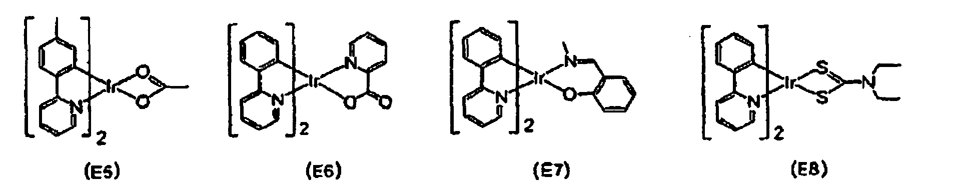

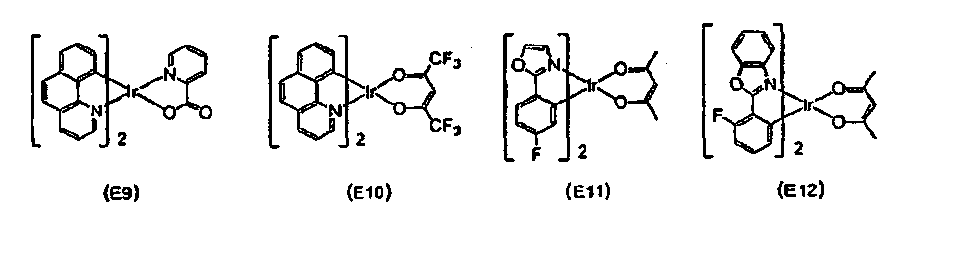

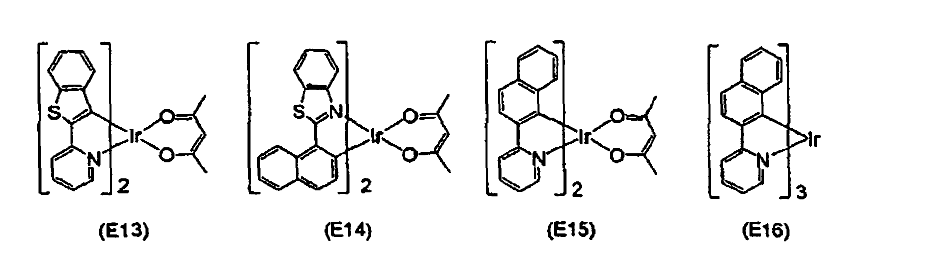

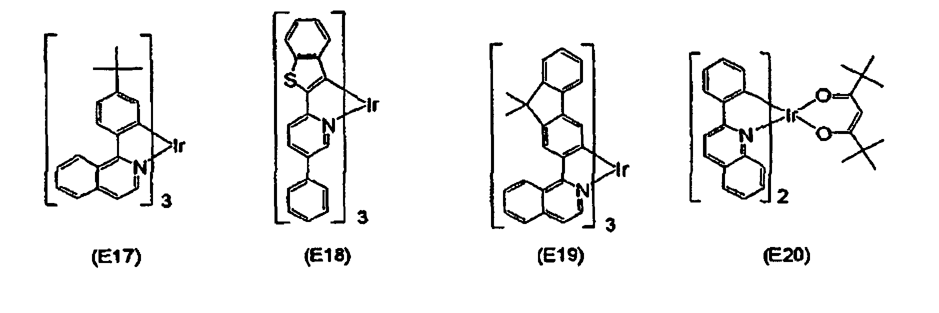

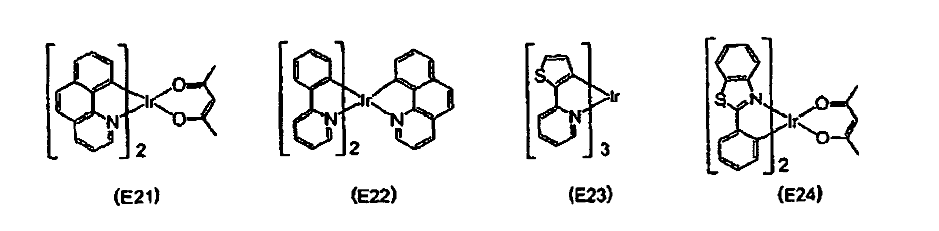

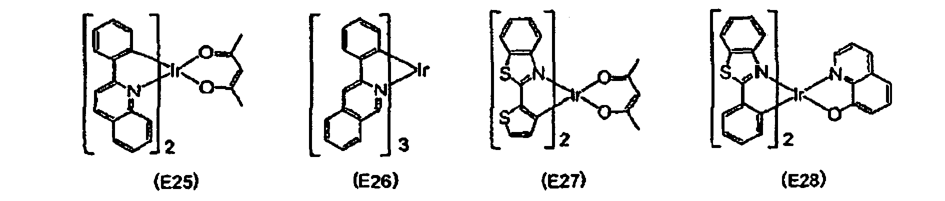

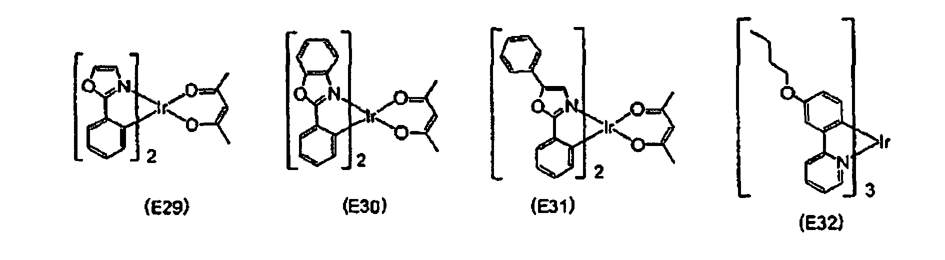

14. Corps électroluminescent selon la revendication 1, dans lequel l'unité luminescente secondaire est préparée en dissolvant ou en dispersant un complexe d'iridium dans un liant et l'unité luminescente secondaire est placée d'une manière telle que la surface d'émission de l'unité luminescente primaire est recouverte.

15. Corps électroluminescent selon la revendication 1, dans lequel l'unité luminescente primaire est une diode électroluminescente bleue.

16. Corps électroluminescent selon la revendication 15, dans lequel l'unité luminescente primaire est un semi-conducteur de composé de nitrure de gallium.

17. Corps électroluminescent selon la revendication 1, comprenant une structure dans laquelle sur un trajet de lumière généré par l'unité luminescente primaire, l'unité luminescente secondaire contenant un liant ayant un complexe d'iridium dissous ou dispersé à l'intérieur et disposé pour émettre de la lumière blanche.

18. Corps électroluminescent selon la revendication 17, dans lequel l'unité luminescente secondaire disposée sur un trajet de lumière généré par l'unité luminescente primaire contient un liant ayant au moins deux types de complexes d'iridium comprenant un complexe d'iridium ayant un pic d'émission dans 510 à 570 nm et un complexe d'iridium ayant un pic d'émission dans 600 à 680 nm dissous ou dispersé à l'intérieur.

19. Corps électroluminescent selon l'une quelconque des revendications 1 à 18, dans lequel l'indice de rendu des couleurs est de 80 ou plus.

20. Corps électroluminescent selon la revendication 18, dans lequel l'unité luminescente primaire est une diode électroluminescente émettant de la lumière ayant une longueur d'onde de 350 à 530 nm et de la lumière blanche avec un indice de rendu des couleurs de 90 ou plus est extraite.

21. Corps électroluminescent selon la revendication 17 ou 18, dans lequel le liant est utilisé comme plaque de guidage de lumière ou plaque déflectrice.

22. Procédé de production du corps électroluminescent selon la revendication 7, dans lequel l'unité luminescente secondaire contenant un complexe d'iridium est formée sur un substrat transparent qui reçoit de la lumière provenant de l'unité luminescente primaire par un procédé quelconque de revêtement, de dépôt à la tournette et d'impression.

23. Procédé de production du corps électroluminescent selon la revendication 7, dans lequel l'unité luminescente secondaire contenant un complexe d'iridium est formée sur la surface d'émission de l'unité luminescente primaire par un procédé quelconque de durcissement après égouttement, impression et étanchéisation, un procédé de distribution, de moulage par transfert, de moulage par injection et de dépôt à la tournette.

24. Dispositif d'éclairage comprenant le corps électroluminescent selon l'une quelconque des revendications 1 à 21.

25. Dispositif d'affichage comprenant le corps électroluminescent selon l'une quelconque des revendications 1 à 21.

26. Dispositif d'affichage 25, utilisant le corps électroluminescent comme rétroéclairage.

27. Dispositif d'affichage selon la revendication 25 ou 26, dans lequel un corps électroluminescent est formé sur une surface de substrat transparent pour être une unité luminescente secondaire, plus loin sur le corps électroluminescent ou sur une surface opposée à la surface sur laquelle le corps électroluminescent est formé, une électrode transparente est formée, et l'électrode transparente est utilisée comme électrode d'un dispositif d'affichage à cristaux liquides transmissif.

28. Dispositif plan électroluminescent comprenant de multiples unités luminescentes primaires, une unité luminescente secondaire qui est excitée par la lumière émise par les unités luminescentes primaires pour émettre de la lumière, une plaque de guidage de lumière, une plaque réflectrice et une plaque déflectrice, où l'unité luminescente secondaire contient un complexe d'iridium comme défini dans la revendication 1.

29. Dispositif plan électroluminescent selon la revendication 28, dans lequel toutes les surfaces de contact des constituants constituant le dispositif plan électroluminescent sont étroitement fixées et intégrées les unes aux autres d'une manière telle que sensiblement aucun air ne peut être présent dans les interfaces.

30. Dispositif plan électroluminescent selon la revendication 29, dans lequel les constituants sont liés avec un agent adhésif ou par thermocompression.

31. Dispositif plan électroluminescent selon la revendication 30, dans lequel l'agent adhésif est une résine époxy ayant un indice de réfraction de 1,4 ou plus ou une résine acrylique ayant un indice de réfraction de 1,4 ou plus.

32. Dispositif plan électroluminescent selon la revendication 31, dans lequel l'unité luminescente secondaire est formée en dissolvant ou en dispersant le complexe d'iridium dans l'agent adhésif pour lier les multiples unités luminescentes primaires avec la plaque de guidage de lumière.

33. Dispositif plan électroluminescent selon la revendication 28, dans lequel les unités luminescentes primaires sont placées dans de multiples creux formés dans la portion latérale de la plaque de guidage de lumière.

34. Dispositif plan électroluminescent selon la revendication 33, dans lequel la section transversale d'une face d'entrée de lumière du creux de la plaque de guidage de lumière a une forme gibbeuse et l'agent adhésif utilisé pour étanchéiser les portions de creux a un indice de réfraction supérieur à l'indice de réfraction de la plaque de guidage de lumière.

35. Dispositif plan électroluminescent selon la revendication 28, dans lequel la plaque réflectrice est une plaque d'aluminium, une plaque d'aluminium revêtue de blanc, un film d'argent évaporé ou un film blanc.

36. Dispositif plan électroluminescent selon la revendication 28, dans lequel les unités luminescentes primaires sont des diodes électroluminescentes.

37. Système de rétroéclairage d'affichage à cristaux liquides utilisant le dispositif plan électroluminescent selon l'une quelconque des revendications 28 à 36.
